# EUROPEAN PATENT SPECIFICATION

(11) **EP 4 373 674 B1**
(45) Date of publication and mention of the grant of the patent: **03.09.2025**
(21) Application number: 22748663.6
(22) Date of filing: 11.07.2022
(51) Int. Cl.: B41C 1/10

(54) **LITHOGRAPHIC PRINTING PLATE PRECURSOR AND METHOD FOR PROVIDING A LITHOGRAPHIC PRINTING PLATE**
LITHOGRAPHIEDRUCKPLATTENVORLÄUFER UND VERFAHREN ZUR BEREITSTELLUNG EINER LITHOGRAPHIEDRUCKPLATTE
PRÉCURSEUR DE PLAQUE D'IMPRESSION LITHOGRAPHIQUE ET MÉTHODE DE PRÉPARATION D'UNE PLAQUE D'IMPRESSION LITHOGRAPHIQUE

(30) Priority: 23.07.2021 US 202163224950 P; 18.01.2022 US 202263300301 P; 14.04.2022 US 202217720405
(43) Date of publication of application: 29.05.2024
(73) Proprietor: Eastman Kodak Company, Rochester, New York 14650-2201 (US)
(72) Inventor: HANSMANN, Stefanie, Rochester, New York 14650 (US); SIMPSON, Christopher D., Rochester, New York 14650 (US); WERNER, Saija, Rochester, New York 14650 (US)
(74) Representative: Vossius & Partner Patentanwälte Rechtsanwälte mbB
(86) International application number: PCT/US2022/036617
(87) International publication number: WO 2023/003712

(56) References cited:
- EP-A1- 3 418 332
- EP-A1- 3 875 282
- JP-A- 2020 069 790

## Description

### FIELD OF THE INVENTION

This invention relates to infrared radiation-sensitive lithographic printing plate precursors that can be imaged using infrared radiation to provide imaged lithographic printing plates. Such precursors include unique infrared radiation-sensitive compositions that provide a stable and more readily detectable printout image between exposed and non-exposed regions in the imagewise exposed infrared radiation-sensitive image-recording layer. This invention also relates to methods of using these precursors to provide lithographic printing plates having excellent printout images.

### BACKGROUND OF THE INVENTION

In lithographic printing, lithographic ink receptive regions, known as image areas, are generated on a hydrophilic surface of a planar substrate such as an aluminum-containing substrate. When the printing plate surface is moistened with water and a lithographic printing ink is applied, hydrophilic regions retain the water and repel the lithographic printing ink, and the lithographic ink receptive image regions accept the lithographic printing ink and repel the water. The lithographic printing ink is transferred to the surface of a material upon which the image is to be reproduced, perhaps with the use of a blanket roller in a printing press.

Negative-working lithographic printing plate precursors useful to prepare lithographic printing plates typically comprise a negative-working radiation-sensitive image-recording layer disposed over the hydrophilic surface of the substrate. Such an image-recording layer includes radiation-sensitive components that can be dispersed in a suitable polymeric binder material. After the precursor is imagewise exposed to suitable radiation to form exposed regions and non-exposed regions in the image-recording layer, the non-exposed regions are removed by suitable means, revealing the underlying hydrophilic surface of the substrate. The exposed regions of the image-recording layer that are not removed are lithographic ink-receptive, and the hydrophilic substrate surface revealed by the developing process accepts water and aqueous solutions such as a fountain solution and repels lithographic printing ink.

In recent years, there has been an increased desire in the lithographic printing industry for simplification in making lithographic printing plates by carrying out development on-press ("DOP") using a lithographic printing ink or fountain solution, or both, to remove non-exposed regions of the image-recording layer.

Thus, on-press developable lithographic printing plate precursors have gained increasing attention in the printing industry in recent decades due to their many benefits over conventionally processed ("off-press" processed or developed) lithographic printing plate precursors, including less environmental impact and savings on processing chemicals, processor floor space, operation and maintenance costs. After laser imaging, on-press developable precursors can be taken directly to the printing press without any prior wet chemical step of removing the imageable coating on the precursors in the non-printing regions.

It is highly desirable that such imaged lithographic printing plate precursors have different colors between the exposed regions and the unexposed regions. The color difference or "contrast" between the exposed and unexposed regions is typically called "printout" or a "printout image." A strong printout will facilitate the operator's visual assessment and identification of the imaged printing plate precursors so that the printing plate precursors can be properly attached to printing press units.

Many approaches have been taken to strengthen the printout of on-press developable printing plate precursors. It has been observed that they all have advantages and disadvantages and that further improvements would be useful.

For example, the printout on exposed IR-sensitive lithographic printing plate precursors having imaging compositions that comprise an acid generator and an acid-sensitive color precursor such as lactone based leuco dyes, is often not strong enough due to the limited efficiency of acid generation in imaging compositions designed for on-press development. Furthermore, the concentration of protons generated during infrared radiation imaging often decreases after imaging through chemical equilibration or other post-imaging chemical reactions. As a result, the printout based on proton-induced color change often fades after imaging.

Moreover, using more sensitive color forming compositions inevitably increases the sensitivity of the lithographic printing plate precursors towards white light. This increased white light sensitivity will cause increased color formation in the non-imaged areas if the precursor is exposed to white light after imaging. This undesirable result reduces the contrast and decreases readability of the printout image.

U.S. Patent Application Publication 2021/0078350 (Viehmann et al.) describes efforts to increase printout by incorporating more sensitive color-forming compounds that switch from colorless forms to colored forms at lower acid concentrations into the infrared radiation-sensitive imaging compositions. Background color formation is suppressed by a special additive to stabilize the good contrast. The initial printout achieved is quite high from the use of certain leuco dyes in the imaging chemistry, but further improvement in printout stability (reduced fading) is a desired goal in the industry. More specifically, the strong printout perceived by the human eye is not always strong enough to be detected by electronic reading devices such as cameras or sensors used to read bar codes, QR codes, data matrices, or other images to provide information for automated processes needed for printing plate sorting after imaging, before punch bending, or for automated printing plate loading to printing units.
JP 2020-069790 A describes lithographic printing plate precursors with an IR absorber in the image recording layer.

Many of the electronic reading devices on the market use, have as a light source, laser diodes that have an emission peak between 600 nm and 700 nm. For example, many of the printing presses made by Koenig & Bauer (KBA) that are used by numerous lithographic printing companies can be equipped with a plate identification system known as DriveTronic Plate Ident that ensures that lithographic printing plates are mounted on the presses in the correct position and order. The DriveTronic Plate Ident plate identification system is a camera-based system that enables the determination of the proper positioning of the lithographic printing plates during a fully automatic plate change. The camera used in the DriveTronic Plate Ident plate identification system has an internal light source emitting at around 620 nm. Printing plates having a large difference in reflective absorbance at 620 nm between the imaged areas and non-imaged areas can generally be read well by the camera in the DriveTronic Plate Ident plate identification system. On the other hand, colored compounds formed from highly acid sensitive color-forming compounds taught by the Viehmann et al. publication noted above have relatively low absorbance in this spectral region and are incapable of providing a large difference in reflective absorbance at 620 nm between the imaged areas and non-imaged areas. Due to such mismatch between emission and absorption peaks, the printout images in such image-recoding layer compositions cannot be readily detected by the common electronic reading devices on the market, despite the relatively high ΔE values useful for visual perception by human eyes.

Thus, there is a need for an infrared sensitive lithographic printing plate precursor comprising an acid-sensitive color forming compound that not only has high acid sensitivity, but is also capable of forming a colored compound that has strong absorption in the spectral range of between 600 nm and 700 nm.

### SUMMARY OF THE INVENTION

The present invention provides a lithographic printing plate precursor comprising:
a substrate, and
an infrared radiation-sensitive image-recording layer disposed on the substrate, the infrared radiation-sensitive image-recording layer comprising the following components (1), (2), (3), (4), and (5):
   (1) a free radical initiator composition that is capable of generating free radicals upon exposure to infrared radiation and comprises a borate compound;
   (2) a free radically polymerizable composition;
   (3) an acid-sensitive color-changing compound that is represented by the following Formula (I): 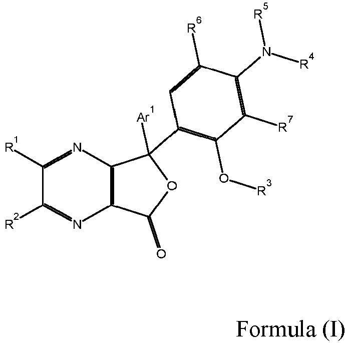 wherein:
      Ar¹ is a substituted or unsubstituted aryl or a substituted or unsubstituted heteroaryl group;
      R¹and R² are independently hydrogen, substituted or unsubstituted alkyl groups, each having 1 to 12 carbon atoms, substituted or unsubstituted aryl groups, or substituted or unsubstituted heteroaromatic groups, or R¹ and R² can be connected to form a fused ring;
      R³ is a substituted or unsubstituted alkyl group having 1 to 12 carbons, a substituted or unsubstituted aryl, or a substituted or unsubstituted heteroaryl group;
      R⁴ and R⁵ are independently hydrogen, substituted or unsubstituted alkyl groups, each having 1 to 12 carbon atoms, substituted or unsubstituted aryl groups, or substituted or unsubstituted heteroaromatic groups; and
      R⁶ and R⁷ are independently hydrogen, or substituted or unsubstituted alkyl groups having 1 to 12 carbons,
      or R⁴ and R⁶ can be linked together to form a cyclic structure, or R⁵ and R⁷ can be linked together to form a cyclic structure, or either or both of R⁴ and R⁵ can be linked to R⁶ and R⁷, respectively;
   (4) an infrared absorbing material; and
   (5) a color-changing compound represented by either Formula (III) or Formula (IV): 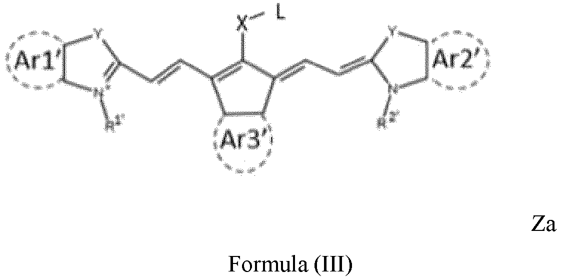 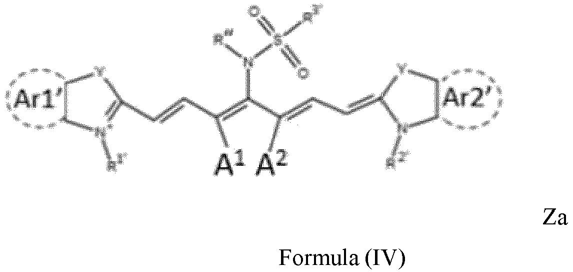 wherein:
      Ar1', Ar2', and Ar3' independently represent the atoms necessary to complete substituted or unsubstituted aromatic rings or to complete substituted or unsubstituted heteroaromatic rings;
      Y represents an oxygen atom, a sulfur atom, or a dialkylmethylene group represented by >C(R^{4'}R^{5'}) wherein R^{4'} and R^{5'} are independently substituted or unsubstituted alkyl groups, each having 1 to 4 carbons;
      R" is hydrogen, a substituted or unsubstituted alkyl group, a substituted or unsubstituted aryl group, or a substituted or unsubstituted heteroaryl group ;
      R^{1'}and R^{2'} are independently substituted or unsubstituted alkyl groups;
      X represents a single bond or a divalent linking group selected from -S-, -O-, and >N(R^{6'}) wherein R^{6'} is hydrogen, a substituted or unsubstituted alkyl group, a substituted or unsubstituted aryl group, a substituted or unsubstituted heteroaryl group, or L;
      L represents a -C(=O)-OR^{7'} group, -SO₂-R^{3'} group, or -SO₂NR^{8'}R^{9'} group, wherein R^{7'} represents a substituted or unsubstituted alkyl group that has a secondary or tertiary connecting carbon that connects to the remainder of the -C(=O)OR^{7'} group; and R^{3'}, R^{8'}, and R^{9'} independently represent substituted or unsubstituted alkyl groups, substituted or unsubstituted aryl groups, or substituted or unsubstituted heteroaryl groups; R^{7'} is hydrogen, a substituted or unsubstituted alkyl group, a substituted or unsubstituted aryl group, or a substituted or unsubstituted heteroaryl group;
      A¹ and A² independently represent substituted or unsubstituted alkyl groups, or together they represent the two or three carbon atoms necessary to form a substituted or unsubstituted 5-or 6-membered non-aromatic carbocyclic ring; and
      Za represents one or more counter ions to balance the electric charge in the rest of the color-changing compound according to Formula (III) or Formula (IV), and
      wherein the borate compound is represented by the following Formula (VI):

         [B(R^{10'}R^{11'}R^{12'}R^{13'})⁻]ₙ Mⁿ⁺ Formula (VI)
      wherein R^{10'}, R^{11'}, R^{12'}, and R^{13'} are independently substituted or unsubstituted alkyl groups or substituted or unsubstituted aryl groups, and at least three of R^{10'}, R^{11'}, R^{12'}, and R^{13'} are substituted or unsubstituted aryl groups; Mⁿ⁺ is an n-valent cation and n is a positive integer.

This invention also provides a method for providing a lithographic printing plate, comprising:
A) imagewise exposing the lithographic printing plate precursor according to any embodiment of the present invention described herein to infrared radiation, to provide exposed regions and non-exposed regions in the infrared radiation-sensitive image-recording layer, and
B) removing the non-exposed regions in the infrared radiation-sensitive image-recording layer.

The present invention provides a strong printout image in regions of an infrared radiation-sensitive image-recording layer exposed to relatively low energy imaging infrared radiation. For example, it is possible to achieve a difference in reflective absorbance between the infrared radiation exposed regions and the infrared radiation non-exposed regions immediately after infrared radiation exposure (Step A in inventive method) of at least 0.02, even at infrared radiation exposure of equal to or less than 120 mJ/cm².

The strong printout image is visible with the human eye as well as with various electronic sensing devices that are often used by press operators in the lithographic printing industry.

These advantages are achieved by the presence of certain acid-sensitive color-changing compounds having a colorless form that is identified herein by Formula (I) and the presence of certain color-changing compound that are represented by Formula (III) or Formula (IV). These compounds have two unique properties: (a) a capability to form desired printout color with a sufficient absorption of the colored form between 600 nm and 700 nm, and (b) a capability of providing strong printout due to the high extinction coefficient of the colored form and high sensitivity of acid-induced transformation from the colorless form to the colored form. The combination of structural features of these compounds provides these desirable advantages of the present invention.

### DETAILED DESCRIPTION OF THE INVENTION

### Definitions

Unless the context indicates otherwise, when used herein, the terms "lithographic printing plate precursor," "precursor," and "IR-sensitive lithographic printing plate precursor" are meant to be equivalent references to embodiments of the present invention.

As used herein, the term "infrared radiation absorber" refers to a compound or material that absorbs electromagnetic radiation in the near-infrared (near-IR) and infrared (IR) regions of the electromagnetic spectrum, and it typically refers to compounds or materials that have an absorption maximum in the near-IR and IR regions.

As used herein, the terms "near-infrared region" and "infrared region" refer to radiation having a wavelength of at least 750 nm and higher. In most instances, the terms are used to refer to the region of the electromagnetic spectrum of at least 800 nm and up to and including 1400 nm.

For the purposes of this invention, the strength of printout images is generally indicated by ΔE, which is the Euclidean distance in CIE 1976 L*a*b* color space between the colors of infrared radiation-exposed regions and infrared radiation non-exposed regions, measured from reflection measurement in 45/0 geometry (non-polarized), using CIE 2° observer and D50 as illuminant according to EN ISO 11664-4 "Colorimetry -- Part 4: CIE 1976 L*a*b* Colour space." and other known references. Color measurements can be done using commercial instruments such as Techkon SpectroDens. In CIE 1976 L*a*b color space, a color is expressed as three numerical color values: L* for the lightness (or brightness) of the color, a* for the green-red component of the color, and b* for the blue-yellow component, of the color values.

Another parameter useful for the purpose of this invention is the optical density (OD) or difference in optical densities, ΔOD, specifically ΔOD_{cyan}, according to DIN 16536, which can be determined by the same device as described above or other spectral densitometers that are commercially available.

For the purpose of this invention, visible spectral region refers to a spectral region for electromagnetic radiation having a wavelength from 400 nm to 700 nm.

Unless otherwise indicated, the term "weight %" refers to the amount of a component or material based on the total solids of a composition, formulation, or layer. Unless otherwise indicated, the percentages can be the same for either a dry layer or the total solids of the formulation or composition.

As used herein, the term "layer" or "coating" can consist of one disposed or applied layer or a combination of several sequentially disposed or applied layers. If a layer is considered infrared radiation-sensitive and negative-working, it is both sensitive to infrared radiation (as described above for "infrared radiation-absorber") and negative-working in the formation of lithographic printing plates.

As used herein, the terms "on-press developable" and "on-press developability" refer to the capability of developing a precursor according to the present invention after infrared radiation exposing (imaging), by mounting the imaged precursor on a suitable printing press, and carrying out development during the first few printed impressions using a fountain solution, a lithographic printing ink, or a combination of a fountain solution and a lithographic printing ink.

### Uses

The lithographic printing plate precursors according to the present invention are useful for providing lithographic printing plates that exhibit desirable printout images after imagewise exposure to infrared radiation. These lithographic printing plates are useful for lithographic printing during press operations. Lithographic printing plates can be prepared after infrared radiation exposure using either on-press processing or off-press processing according to this invention. The lithographic printing plate precursors are prepared with the structure and components described as follows.

### Lithographic Printing Plate Precursors

The precursors according to the present invention can be formed by suitable application of an infrared radiation-sensitive image-recording composition (as described below) to a suitable substrate (as described below) to form an infrared radiation-sensitive image recording layer that is negative-working. In general, the infrared radiation-sensitive image-recording composition (and resulting infrared radiation-sensitive image-recording layer) comprises four essential components: component (1) a free radical initiator composition that is capable of generating free radicals and protons upon exposure of the infrared-sensitive imaging-recording composition to infrared radiation; component (2) a free radically polymerizable composition; component (3) an acid-sensitive color-changing compound that is represented by the Formula (I) described below; component (4) infrared absorbing material (or a mixture of two or more thereof); and component (5) a color-changing compound represented by Formula (III) or Formula (IV). All of these components (1), (2), (3), (4), and (5) are defined in detail below, and these components are the only essential components necessary to achieve the advantages of the present invention.

In some embodiments, the infrared radiation-sensitive image-recording composition (and resulting infrared radiation-sensitive image-recording layer) can further comprise component (6) non-free radically polymerizable polymeric material (or mixture of two or more thereof) that is different from all of the components (1), (2), (3), (4) and (5). In some highly useful embodiments, the infrared radiation-sensitive image recording layer consists essentially of all of the noted components (1) through (6) to provide a desired lithographic printing plate precursor with desirable printout image and the best overall imaging and printing properties.

Each precursor of the present invention generally comprises an infrared radiation-sensitive image-recording layer as the outermost layer in the precursor, but in some embodiments, there can be an outermost water-soluble hydrophilic protective layer (also known as a topcoat or oxygen barrier layer), as described below, disposed over (or directly on and in contact with) the infrared radiation-sensitive image-recording layer.

### Substrate:

The substrate that is used to prepare the precursors according to this invention generally has a hydrophilic imaging-side surface, or at least a surface that is more hydrophilic than the applied infrared radiation-sensitive image-recording layer. The substrate generally comprises an aluminum-containing support that can be composed of raw aluminum or a suitable aluminum alloy that is conventionally used to prepare lithographic printing plate precursors.

The aluminum-containing substrate can be treated using techniques known in the art, including roughening of some type by physical (mechanical) graining, electrochemical graining, or chemical graining, which is followed by one or more anodizing treatments. Each anodizing treatment is typically carried out using either phosphoric acid or sulfuric acid and conventional conditions to form a desired hydrophilic aluminum oxide (or anodic oxide) layer on the aluminum-containing support. A single aluminum oxide (anodic oxide) layer can be present or multiple aluminum oxide layers (for example an inner aluminum oxide layer and an outer aluminum oxide layer disposed on the inner aluminum oxide layer) can be present, each anodic layer having multiple pores with varying depths and shapes of pore openings. Such anodizing processes thus provide an anodic oxide layer(s) or aluminum oxide layer(s) underneath an infrared radiation-sensitive image-recording layer that can be provided as described below. A discussion of such pores and a process for controlling their width and depth is provided for example, in U.S. Patent Publications 2013/0052582 (Hayashi), 2014/0326151 (Namba et al.), and 2018/0250925 (Merka et al.), and U.S. Patents 4,566,952 (Sprintschnik et al.), 8,789,464 (Tagawa et al.), 8,783,179 (Kurokawa et al.), and 8,978,555 (Kurokawa et al.), as well as in EP 2,353,882 (Tagawa et al.). Teachings about providing two or more sequential anodizing treatments to provide different aluminum oxide layers in a substrate are described for example, in U.S. Patent Application Publication 2018/0250925 (noted above), U.S. Patent Application Publication 2021/0094336 (Merka et al.). and U.S. Patent 4,865,951 (Huddleston et al.).

An anodized aluminum-containing support can be further treated to seal the anodic oxide pores or to hydrophilize its surface, or both, using known post-anodic treatment processes, such as post-treatments using aqueous solutions of hydrophilic materials. Representative hydrophilic materials of this type to provide a hydrophilic layer (or hydrophilic polymer coating) include but are not limited to poly(vinyl phosphonic acid) (PVPA), vinyl phosphonic acid copolymers, poly[(meth)acrylic acid] or its alkali metal salts, or (meth)acrylic acid copolymers or their alkali metal salts, mixtures of phosphate and fluoride salts, or sodium silicate. Such hydrophilic coatings can be disposed on the outermost aluminum oxide layer (such as an outer aluminum oxide layer if multiple aluminum oxide layers are present). Useful post-treatment processes include dipping the substrate with rinsing, dipping the substrate without rinsing, and various coating techniques such as extrusion coating.

Some useful hydrophilic polymer coating materials comprise: one or more hydrophilic polymers, at least one of which hydrophilic polymers is a hydrophilic copolymer that comprises at least (a) recurring units comprising an amide unit, and (b) recurring units comprising an -OM' group that is directly connected to a phosphorus atom, wherein M' represents a hydrogen, sodium, potassium, or aluminum atom. This hydrophilic layer can be disposed over the outermost aluminum oxide layer at a dry coverage of at least 0.0002 g/m² and up to and including 0.1 g/m².

The thickness of a substrate can be varied but should be sufficient to sustain the wear from printing and thin enough to be wrapped around a printing form.

The substrate can be formed as a continuous roll (or continuous web) of sheet material that is suitably coated with an infrared radiation-sensitive image-recording layer formulation and optionally a hydrophilic protective layer formulation, followed by slitting or cutting (or both) to size to provide individual lithographic printing plate precursors having a shape or form having four right-angled corners (thus, typically planar or generally flat, and in a square or rectangular shape or form).

### Infrared Radiation-sensitive Image-recording Layer:

The infrared radiation-sensitive image-recording layer composition (and infrared radiation-sensitive image-recording layer prepared therefrom) according to the present invention is designed to be "negative-working" as that term is known in the lithographic art. In addition, the infrared radiation-sensitive image-recording layer can be designed with a certain combination of components to provide on-press developability to the lithographic printing plate precursor after exposure, for example to enable on-press development using a fountain solution, a lithographic printing ink, or a combination of the two.

The present invention utilizes component (1) a free radical initiator composition that is capable of generating free radicals and protons upon exposure of the infrared radiation-sensitive image-recording layer to infrared radiation. Such component (1) free radical initiator composition can comprise one or more organohalogen compounds, for example trihaloalkyl compounds; halomethyl triazines; bis(trihalomethyl) triazines; or one or more onium salts such as iodonium salts, sulfonium salts, many of which are known in the art as being capable of generating free radicals and protons upon infrared radiation exposure of infrared-absorbing compositions comprising such compounds. Representative compounds other than onium salts are described for example in [0087] to [0102] of U.S. Patent Application Publication 2005/0170282 (Inno et al., US '282) and U.S. Patent 6,309,792 (Hauck et al.) including the numerous cited publications describing such compounds, and also in Japanese Patent Publication 2002/107916 and WO 2019/179995.

For example, the component (1) free radical initiator composition can include an onium salt for example, comprising an iodonium cation or sulfonium cation, or both. Useful onium salts are described for example from [0103] to [0109] of the cited US publication '282. For example, useful onium salts comprise at least one onium cation in the molecule, and a suitable anion. Examples of the onium salts include triphenylsulfonium and diphenyliodonium salts and derivatives thereof that are obtained by introducing one or more substituents into the benzene ring of these compounds. Particularly useful onium cations for the onium salts include iodonium cations such as diaryliodonium cations, for example having two substituted or unsubstituted phenyl groups.

Examples of anions in onium salts include but are not limited to, halogen anions, ClO₄⁻, PF₆⁻, BF₄⁻, SbF₆⁻, CH₃SO₃⁻, CF₃SO₃⁻, C₆H₅SO₃⁻, CH₃C₆H₄SO₃⁻, HOC₆H₄SO₃⁻, ClC₆H₄SO₃⁻, and boron anions as described for example in U.S. Patent 7,524,614 (Tao et al.). Representative useful iodonium salts are described in in Cols. 6-7.

Furthermore, the onium salts described in paragraphs [0033] to [0038] of the specification of Japanese Patent Publication 2002-082429 [or U.S. Patent Application Publication 2002-0051934 (Ippei et al.)] are useful. Representative iodonium borate salts are for example, listed in Col. 8 of U.S. Patent 7,524,614 (noted above).

In some embodiments, a combination of onium salts can be used as part of the component (1) free radical initiator composition, for example a combination of compounds described in U.S. Patent Application Publication 2017/0217149 (Hayashi et al.).

The (1) free radical initiator composition should comprise one or more borate compounds. Some useful borate compounds can be represented by the following Formula (VI):

[B(R^{10'}R^{11'}R^{12'}R^{13'})⁻]ₙ Mⁿ⁺ Formula (VI)

wherein R^{10'}, R^{11'}, R^{12'}, and R^{13'} are independently substituted or unsubstituted alkyl groups (each having 1 to 12 carbon atoms and can be linear or branched), or substituted or unsubstituted aryl groups (such as substituted or unsubstituted phenyl or naphthyl groups), and at least three of R^{10'}, R^{11'}, R^{12'}, and R^{13'} are the same or different, substituted or unsubstituted aryl groups (such as substituted or unsubstituted phenyl groups); Mⁿ⁺ is an n-valent cation and n is a positive integer. A tetraphenyl borate salt is particularly useful.

The component (1) free radical initiator composition is present in the infrared radiation-sensitive image-recording layer in amounts (molar or weight ratios) that would be readily apparent to a skilled worker in the art of preparing on-press developable lithographic printing plate precursors, and the minimum and maximum total amounts are generally at least 1 weight % and up to and including 20 weight % of all materials, based on the total coverage (solids) of the infrared radiation-sensitive image-recording layer.

Since the component (1) free radical initiator composition can have multiple materials it would be readily apparent to one skilled in the art as to the useful amount(s) or dry coverage of the various materials of the component (1) free radical initiator composition in the infrared radiation-sensitive image-recording layer, based on the knowledge of a skilled artisan and the representative teaching provided herein including the working examples shown below.

A second essential feature of the infrared radiation-sensitive image-recording layer is the component (2) free radically polymerizable composition that comprises one or more free radically polymerizable components, each of which contains one or more free radically polymerizable groups that can be polymerized using free radical initiation during infrared radiation exposure. In some embodiments, at least two free radically polymerizable components, having the same or different numbers of free radically polymerizable groups in each molecule, are present. Thus, useful (2) free radically polymerizable compositions can contain one or more free radical polymerizable monomers or oligomers having one or more polymerizable ethylenically unsaturated groups (for example, two or more of such groups). Similarly, crosslinkable polymers having such free radically polymerizable groups can also be used. Oligomers or prepolymers, such as urethane acrylates and methacrylates, epoxide acrylates and methacrylates, polyester acrylates and methacrylates, polyether acrylates and methacrylates, and unsaturated polyester resins can be used.

It is possible for one or more materials in the (2) free radically polymerizable composition to have large enough molecular weight or to have sufficient polymerizable groups to provide a crosslinkable polymer matrix that functions as a "polymeric binder" for other materials in the infrared radiation-sensitive image-recording layer. In such embodiments, a distinct (6) non-free radically polymerizable polymer material (described below) is not necessary but can still be present if desired.

Useful materials in the (2) free radically polymerizable composition can include urea urethane (meth)acrylates or urethane (meth)acrylates having multiple (two or more) polymerizable groups. For example, urethane acrylates having at least two and up to and including fifteen acrylate groups can be prepared by reacting a triisocyanate such as DESMODUR^{®} N100 (Bayer Corp., Milford, Conn.) or reacting a diisocyanate such as hexane-1,6-diisocyanate with hydroxyethyl acrylate, pentaerythritol triacrylate, or dipentaerythritol pentaacrylate. Such urethane or urea (meth)acrylate compounds have the number of (meth)acrylate groups per molecule as high as fifteen or more. Commercially available urethane acrylates having fifteen acrylate groups include U-15HA and UA-53H available from Shin-Nakamura Chemical Co. Ltd. These compounds with large number of (meth)acrylates can be included in the (2) free radically polymerizable composition for their high crosslinking efficiency.

Other useful materials in the (2) free radically polymerizable composition can include non-urethane and non-urea (meth)acrylates derived from polyfunctional alcohols such as NK Ester A-DPH (dipentaerythritol hexaacrylate) that is available from Kowa American, and Sartomer SR399 (dipentaerythritol pentaacrylate), Sartomer 355 (di-trimethylolpropane tetraacrylate), Sartomer SR295 (pentaerythritol tetraacrylate), Sartomer SR415 [ethoxylated (20)trimethylolpropane triacrylate], Sartomer SR494 (ethoxylated pentaerythritol tetraacrylate) that are available from Sartomer Company, Inc.

Mixtures of urethane or urea (meth)acrylate) and non-urethane and non-urea (meth)acrylates can be used in the (2) free radically polymerizable composition. In some embodiments, mixtures of compounds with different number of (meth)acrylate groups can be used.

Numerous other materials in the (2) free radically polymerizable composition are known in the art and are described in considerable literature including Photoreactive Polymers: The Science and Technology of Resists, A Reiser, Wiley, New York, 1989, pp. 102-177, by B.M. Monroe in Radiation Curing: Science and Technology, S.P. Pappas, Ed., Plenum, New York, 1992, pp. 399-440, and in "Polymer Imaging" by A.B. Cohen and P. Walker, in Imaging Processes and Material, J.M. Sturge et al. (Eds.), Van Nostrand Reinhold, New York, 1989, pp. 226-262. For example, useful free radically polymerizable components are also described in EP 1,182,033A1 (Fujimaki et al.), beginning with paragraph [0170], and in U.S Patents 6,309,792 (Hauck et al.), 6,569,603 (Furukawa), and 6,893,797 (Munnelly et al.). Other useful free radically polymerizable components include those described in U.S. Patent Application Publication 2009/0142695 (Baumann et al.).

The materials in the component (2) free radically polymerizable composition are generally present in a collective amount of at least 10 weight % or of at least 20 weight %, and up to and including 50 weight %, or up to and including 70 weight %, all based on the total coverage (solids) of the infrared radiation-sensitive image-recording layer.

A third essential component of the infrared radiation-sensitive image-recording composition and image-recording layer according to the present invention is a component (3) acid-sensitive color-changing compound, or a mixture of two or more thereof, each of which is represented by the following Formula (I):

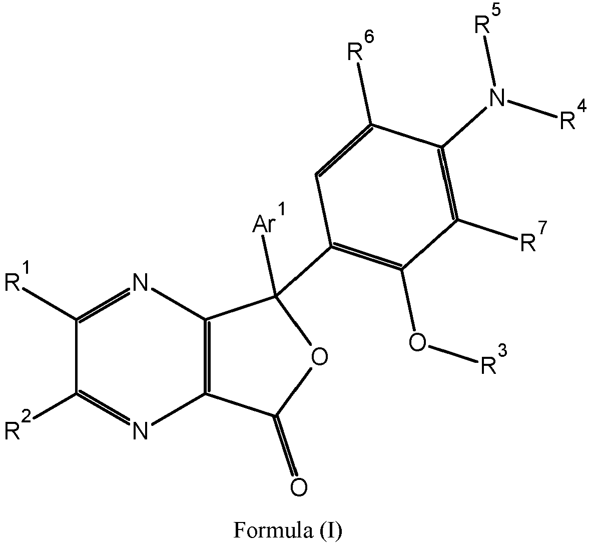

Three distinguishing features of the pyrazine-based or 4,7-diazaphthalide-based leuco dyes represented in Formula (I) are the two nitrogen atoms in the fused heterocyclic group on the left side of the structure and the oxy linkage for R³ to the benzyl ring. The overall chemical structure of Formula (I) provides a sufficiently strong absorption in its colored form (as its protonated form) within the wavelength range of at least 575 nm and up to and including 750 nm and thus is capable of providing a large difference in reflective absorbance between imaged areas and non-imaged areas of the infrared radiation-sensitive image-recording composition and image-recording layer at the emission wavelengths of light sources used by cameras in press automation systems such as 620 nm for the KBA DriveTronic Plate Ident plate identification system. The reflective absorbance at a given wavelength is defined as log₁₀(Iᵣ/Iᵢ) wherein Iᵢ is the light intensity of incident light, Iᵣ is the light intensity of reflected light off a sample surface such as the surface of a lithographic printing plate precursor in the infrared radiation exposed region or in the infrared radiation non-exposed region and log₁₀ represents a 10-based logarithm function. The reflective absorbance can be measured using a commercially available reflective-measuring device such as a Techkon SpectroDens device available from TECHKON GmbH. For compatibility with press automation systems such as the KBA DriveTronic Plate Ident plate identification system, the difference in reflective absorbance at 620 nm between infrared radiation exposed regions and infrared radiation non-exposed regions of an imaged lithographic printing plate precursor is generally at least 0.02, and more desirably at least 0.05.

In order to ensure a sufficiently strong absorption within the electromagnetic spectrum wavelength range of at least 575 nm and up to and including 750 nm, the wavelength of maximum absorption (λₘₐₓ) of the compound in its colored form or peak absorption is generally in the range of at least 575 nm and up to and including 750 nm. In some embodiments, a sufficiently strong absorption (peak wavelength or non-peak wavelength) within the wavelength range of at least 600 nm and up to and including 700 nm is provided, and even more desirably, the wavelength of maximum absorption (λₘₐₓ) of the compound it its colored form (or peak absorption) is in the range of at least 600 nm and up to and including 700 nm upon opening of the lactone ring in the presence of a proton. These compounds have the capability of providing strong printout that is driven by the high extinction coefficient of the colored form of the compound and the high sensitivity of acid-induced transformation from the colorless form to the colored form.

More specifically in Formula (I), Ar1 is a substituted or unsubstituted aryl group or a substituted or unsubstituted heteroaryl group (as defined below). For example Ar1 can be a substituted or unsubstituted benzyl or naphthyl group. Useful substituents for such groups include but are not limited to, alkyl groups, alkoxy groups, halo groups, cyano group, -COOR' group, -SO₃R' group, and -SO₂R' group, wherein R' represents a substituted or unsubstituted alkyl group having 1 to 12 carbon atoms (including linear and branched alkyl groups), any of which substituents can be further substituted.

Useful substituted or unsubstituted heteroaryl groups include but are not limited to, substituted or unsubstituted, pyridin-2-yl, pyridin-3-yl, pyridin-4-yl, pyridazinyl, pyrimidin-2-yl, pyrimidin-4-yl, pyrimidin-5-yl, or pyrimidin-6-yl, pyrazinyl, triazinyl, pyrrolyl, furanyl, thiophenyl, pyrazolyl, oxazolyl, imidazolyl, thiazolyl, and triazolyl groups. Useful substituents for these heteroaryl groups include those listed above for the aryl groups.

Particularly useful Ar1 groups are those shown as the following three moieties: 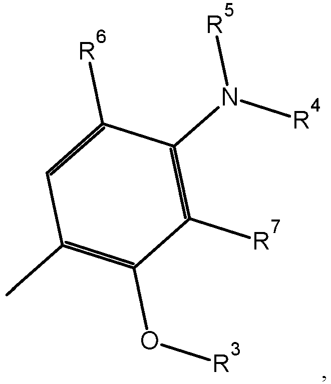 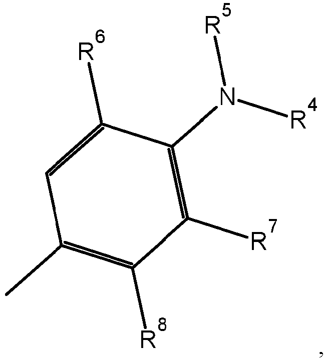 and 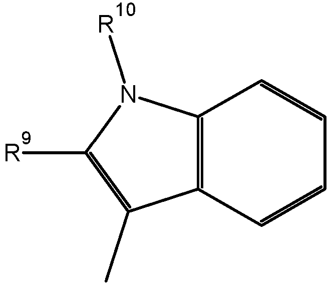 wherein R³, R⁴, R⁵, R⁶, and R⁷ are defined hereinbelow, and R⁸, R⁹, and R¹⁰ are independently hydrogen, or substituted or unsubstituted alkyl groups having 1 to 12 carbon atoms (including linear and branched alkyl groups).

In Formula (I), R¹and R² are independently hydrogen or a substituted or unsubstituted alkyl group, each of which has from 1 to 6 carbon atoms, or even from 1 to 12 carbon atoms, including linear and branched, noncyclic, alkyl groups. In many embodiments, one or both of such substituted or unsubstituted alkyl groups can comprise the same or different ether or ester groups that interrupt the carbon chain, or in the case of ester groups, they can be used to terminate the alkyl chain. Optional substituents on the alkyl groups can be defined as the optional substituents described above for Ar1.

R¹ and R² can also independently be a substituted or unsubstituted aryl group, each having 6 or 10 carbon atoms in the aromatic ring, or a substituted or unsubstituted heteroaromatic group, each having 5 to 10 carbon and heteroatoms in the heteroaromatic ring. Substituents can be any of those described above for the substituted alkyl groups.

Moreover, R¹ and R² can be connected to form a fused ring connected to the aromatic ring to which they are attached. Such ring can be aromatic or non-aromatic and can have any number of atoms in the ring that are chemically possible and useful in the present invention. Such fused ring can be unsubstituted or substituted with one or more substituents as described above for the alkyl groups.

In addition, R³ is a substituted or unsubstituted alkyl group having 1 to 12 carbons (or having 1 to 6 carbon atoms), including linear or branched alkyl groups, or a substituted or unsubstituted aryl group (such as substituted or unsubstituted phenyl or naphthyl group), or a substituted or unsubstituted heteroaryl group (such as a substituted or unsubstituted groups noted above). Useful substituted or unsubstituted alkyl groups and optional substituents can have the same definition as those described above for R¹ and R². Useful aryl groups and heteroaryl groups and optional substituents can have the same definition as those described above for Ar1.

R⁴ and R⁵ are independently hydrogen, substituted or unsubstituted alkyl groups, each having 1 to 12 carbon atoms (or having 1 to 6 carbon atoms), substituted or unsubstituted aryl groups, or substituted or unsubstituted heteroaromatic groups, which groups and optional substituents, can have the same definition as those described above for R¹ and R².

R⁶, R⁷, R⁸, R⁹, and R¹⁰ are independently hydrogen, or substituted or unsubstituted alkyl groups, each having 1 to 12 carbons (or each having 1 to 6 carbon atoms), which substituted or unsubstituted alkyl groups, and optional substituents can have the same definition as those described above for R¹ and R².

Alternatively, either R⁴ and R⁶ can be linked together to form a cyclic structure, or optionally R⁵ and R⁷ can be linked together to form a cyclic structure. Each of such cyclic structures can be optionally substituted with one or more substituents such as those described above for R¹ and R². Alternatively, either R⁴ and R⁵, or both of R⁴ and R⁵, can be linked to R⁶ or R⁷, respectively.

The component (3) acid-sensitive color-changing compound of Formula (I), singly or mixture of two or more thereof, are generally present in the infrared radiation-sensitive image-recording layer in an amount of at least 0.5 weight % or at least 1 weight % and up to and including 10 weight % or up to and including 15 weight %, based on the total coverage (solids) of that infrared radiation-sensitive image-recording layer.

Some useful (3) acid-sensitive color-changing compounds can be represented by the following Formula (II): 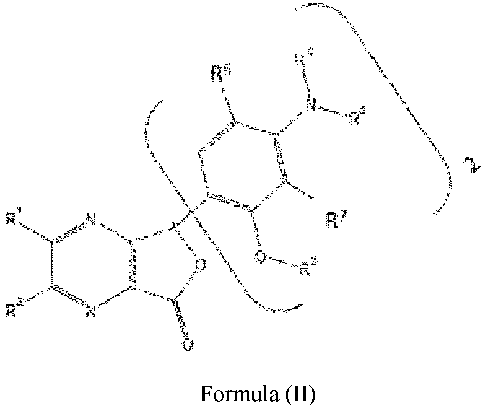 wherein R¹ through R⁷ have the same definitions or meanings as for Formula (I).

In addition, some useful compounds within the scope of Formula (I) include but are not limited to, 3,3-bis-(4-dialkylamino-2-methoxyphenyl)-4,7-diazaphthalide; 3,3-bis-(4-dialkylamino-2-ethoxyphenyl)-4,7-diazaphthalide; 3-(4-diethylamino-2-ethoxyphenyl) -3- (1-ethyl-2-methylindol-3-yl) -4,7-diazaphthalide; 3-(2-methoxy-4-di-*n*-hexylaminophenyl)-3-(1-*n*-octyl-2-methylindol-3-yl)-4,7-diazaphthalide; and 3-(1-n-octyl-2-methylindol-3-yl)-3-(2-ethoxy-4-diethylamino phenyl)-4,7-diazaphthalide.

Additional useful compounds within the scope of Formula (I) are shown as follows: 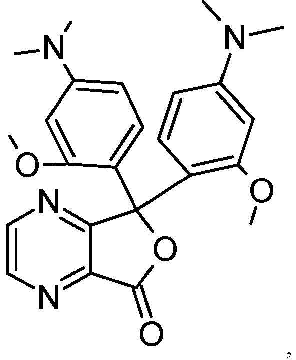 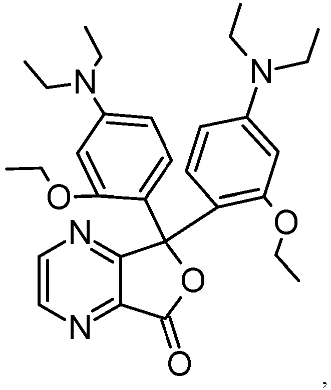 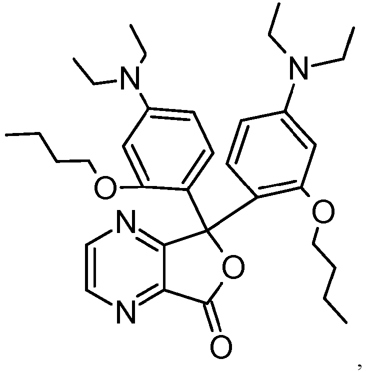 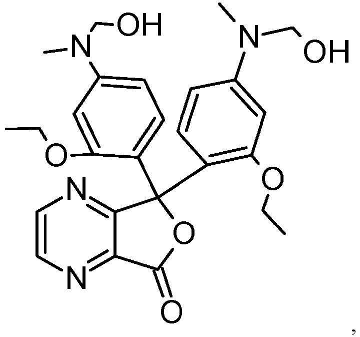 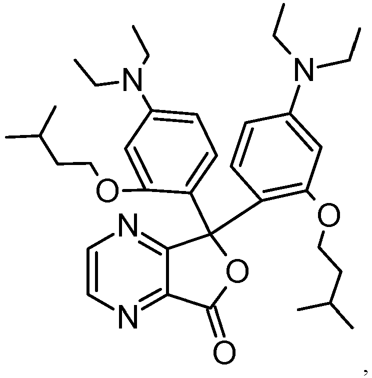 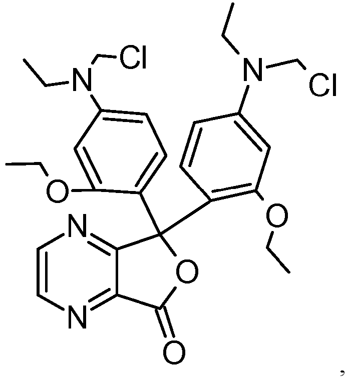 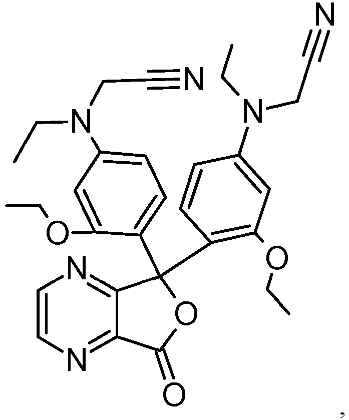 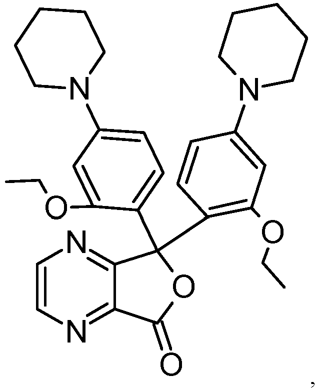 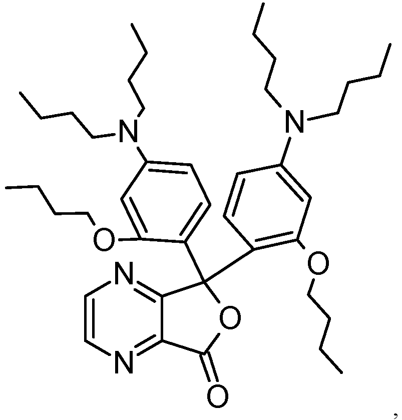 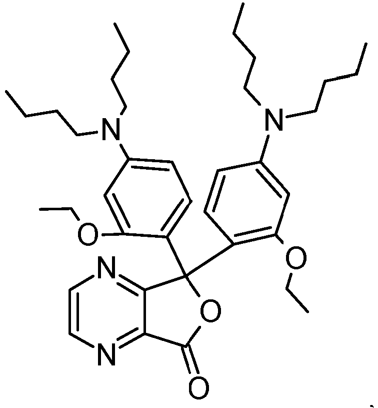 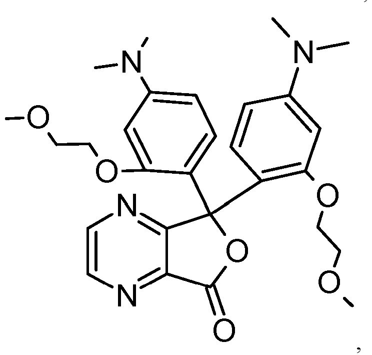 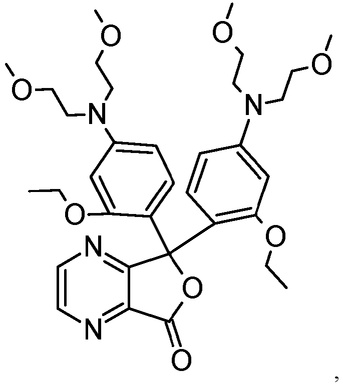 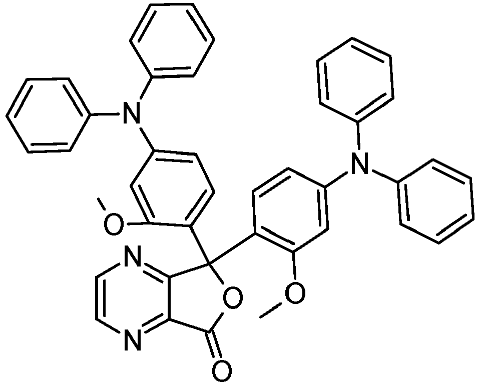 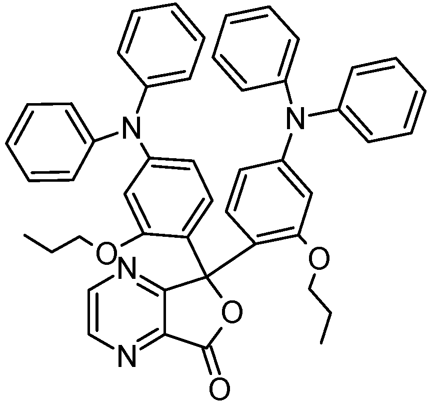 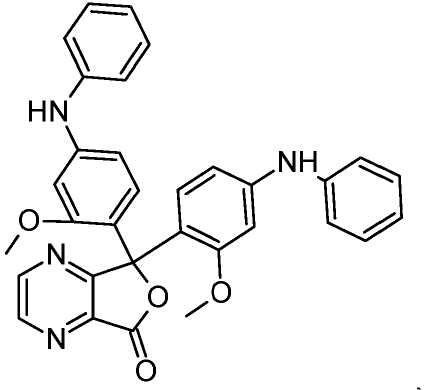 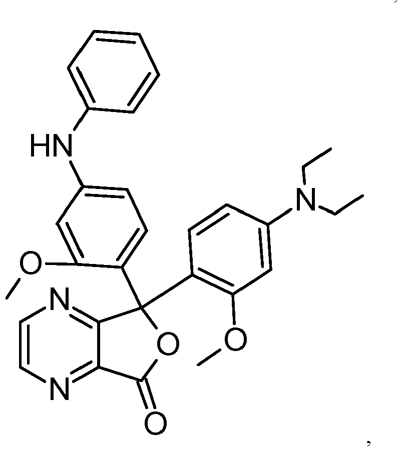 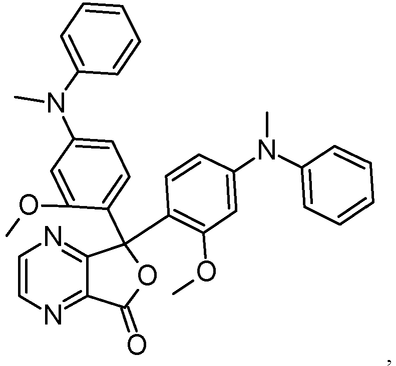 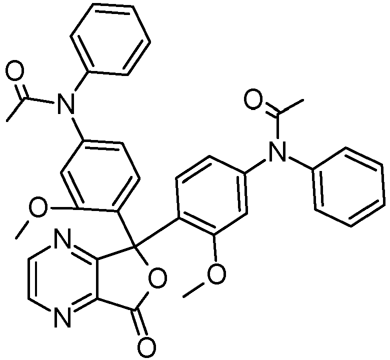 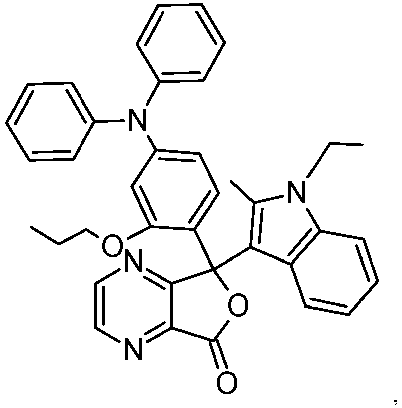 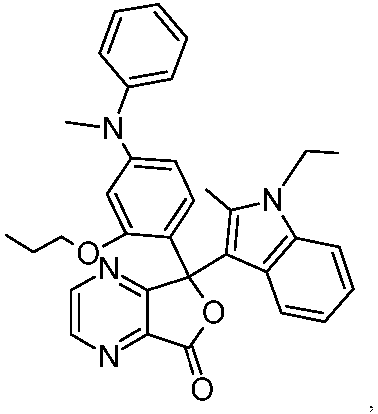 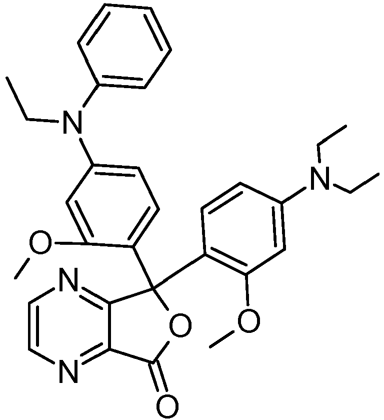 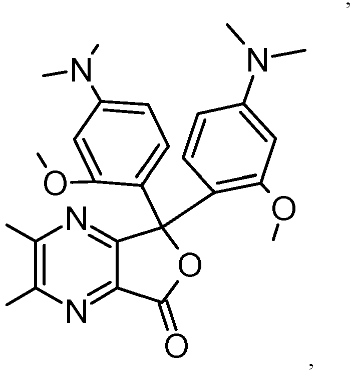 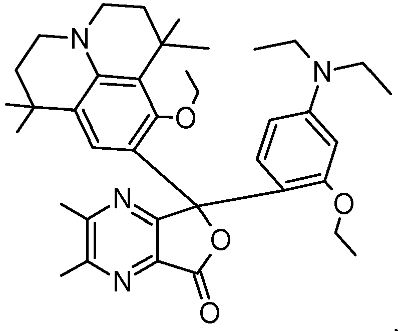 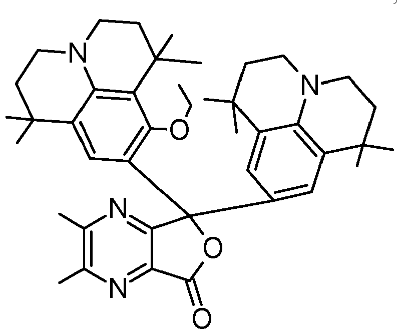 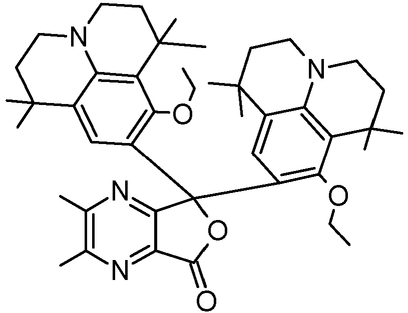 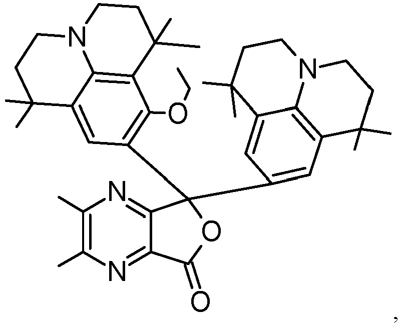 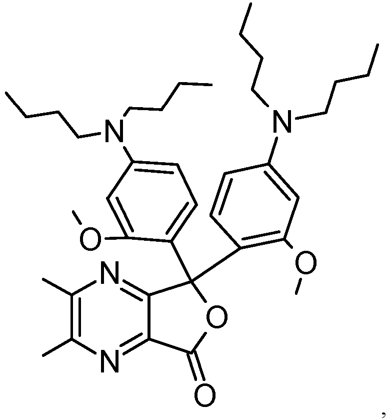 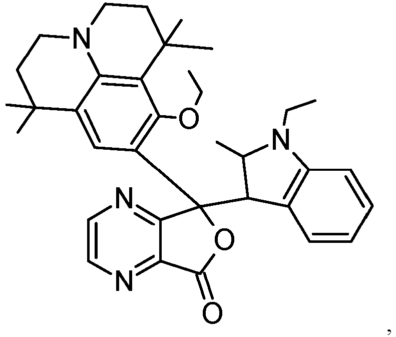 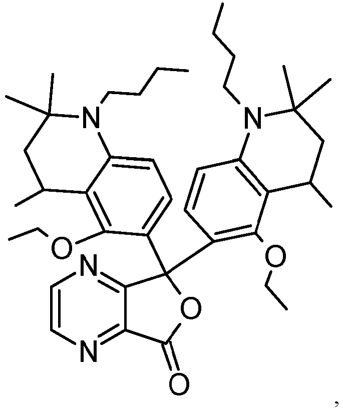 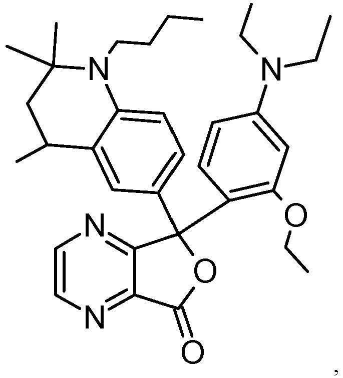 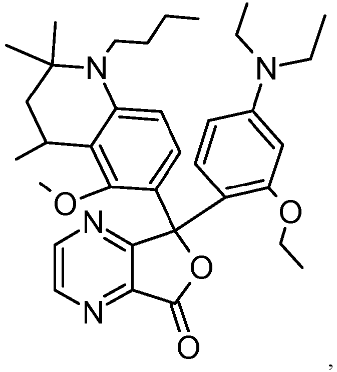 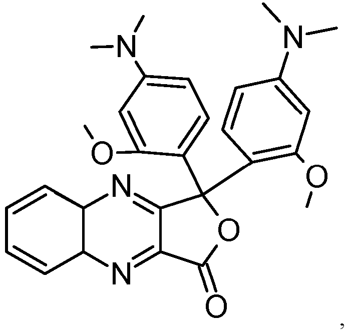 and

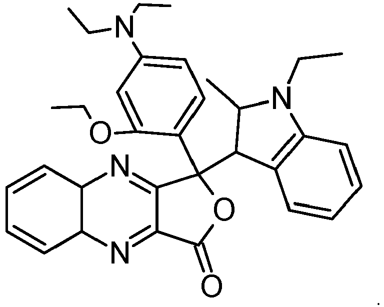

The infrared radiation-sensitive image-recording layer according to the present invention should also include a component (4) infrared absorbing material (one or a mixture of two or more thereof). The (4) infrared absorbing material provides desired infrared radiation sensitivity or converts radiation to heat, or both. Useful (4) infrared absorbing materials can be pigments or infrared radiation (including near-IR) absorbing dyes. Suitable IR-absorbing dyes are those described in for example, U.S. Patents 5,208,135 (Patel et al.), 6,153,356 (Urano et al.), 6,309,792 (Hauck et al.), 6,569,603 (Furukawa), 6,797,449 (Nakamura et al.), 7,018,775 (Tao), 7,368,215 (Munnelly et al.), 8,632,941 (Balbinot et al.), and U.S. Patent Application Publication 2007/056457 (Iwai et al.). In some infrared radiation-sensitive image-recording layer embodiments, it is desirable that at least one (4) infrared absorbing material in the infrared radiation-sensitive image-recording layer be a cyanine dye comprising a suitable cationic cyanine chromophore and a tetraarylborate anion such as a tetraphenylborate anion. Examples of such cyanine dyes include those described in United States Patent Application Publication 2011/003123 (Simpson et al.).

In addition to low molecular weight IR-absorbing dyes, IR dye chromophores bonded to polymers can be used as well. Moreover, IR dye cations can be used as well, that is, the cation is the IR absorbing portion of the dye salt that ionically interacts with a polymer comprising carboxy, sulfo, phospho, or phosphono groups in the side chains.

The total amount of the component (4) infrared absorbing material is at least 0.5 weight % or at least 1 weight %, and up to and including 15 weight %, or up to and including 30 weight %, based on the total dry coverage (solids) of the infrared radiation-sensitive image-recording layer.

While the component (3) acid-sensitive color-changing compound can provide a strong printout image suitable for reading by cameras used in press automation systems such as the KB DriveTronic Plate Ident plate identification system, according to the present invention one or more component (5) color-changing compounds are used for stable and strong visual printout images that are readable by human eyes. Useful (5) color-changing compounds of this type are described in co-pending provisional applications U.S. Serial No. 63/169,278 filed April 1, 2021, and U.S. Serial No. 63/169,279 filed April 1, 2021. These (5) color-changing compounds are particularly useful when the (1) free radical initiator composition comprises a borate compound.

Thus, particularly useful (5) color-changing compounds are those represented by the following Formula (III) or Formula (IV): 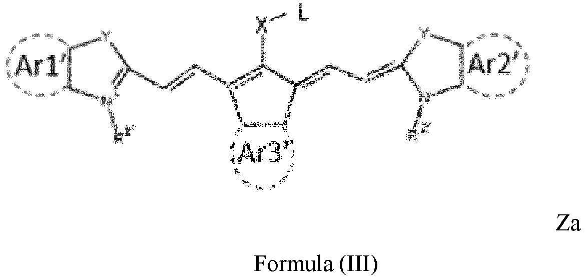 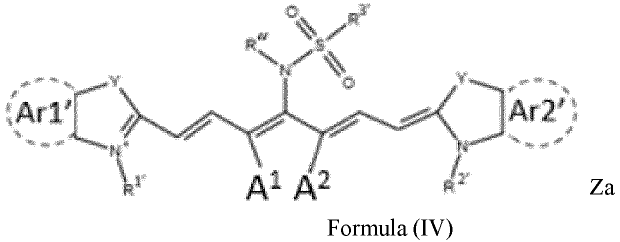 wherein:
Ar1', Ar2', and Ar3' independently represent the atoms necessary to complete substituted or unsubstituted aromatic rings (such as substituted or unsubstituted phenyl and naphthyl rings) or to complete substituted or unsubstituted heteroaromatic rings (such as pyridine and pyrazine rings);
Y represents an oxygen atom, a sulfur atom, or a dialkylmethylene group represented by >C(R^{4'}R^{5'}) wherein R^{4'} and R^{5'} are independently substituted or unsubstituted alkyl groups each having 1 to 12 carbon atoms (including both linear and branched alkyl groups), each having 1 to 4 carbons (which alkyl groups can be linear or branched alkyl groups);
R^{1'}and R^{2'} are independently substituted or unsubstituted alkyl groups, for example each having 1 to 12 carbon atoms, and can be linear or branched alkyl groups);
R" is hydrogen, a substituted or unsubstituted alkyl group (for example having 1 to 12 carbon atoms, including both linear or branched alkyl groups), a substituted or unsubstituted aryl group (such as a substituted or unsubstituted phenyl or naphthyl group), or a substituted or unsubstituted heteroaryl groups (such as substituted or unsubstituted pyridinyl, pyrazinyl, pyrimidinyl, pyrrolyl, furanyl, or thiophenyl groups);
X represents a single bond or a divalent linking group selected from -S-, -O-, and >N(R^{6'}), wherein R^{6'} is hydrogen, a substituted or unsubstituted alkyl group having 1 to 12 carbon atoms (including both linear and branched alkyl groups), a substituted or unsubstituted aryl group (such as a substituted or unsubstituted phenyl or naphthyl group), a substituted or unsubstituted heteroaryl group (such as a substituted or unsubstituted pyridyl, pyrazinyl, pyrimidinyl, pyrrolyl, furanyl, or thiophenyl group), or L;
L represents a -C(=O)-OR^{7'} group, -SO₂-R^{3'} group, or -SO₂NR^{8'}R^{9'} group, wherein R^{7'} represents a substituted or unsubstituted alkyl group having 1 to 12 carbon atoms (including both linear and branched alkyl groups) and that has a secondary or tertiary connecting carbon that connects to the remainder of the -C(=O)OR^{7'} group; and R^{3'}, R^{8'}, and R^{9'} independently represent substituted or unsubstituted alkyl groups each having 1 to 12 carbon atoms (including both linear and branched alkyl groups), substituted or unsubstituted aryl groups (such as substituted or unsubstituted phenyl or naphthyl groups), or substituted or unsubstituted heteroaryl groups (such as substituted or unsubstituted pyridinyl, pyrazinyl, pyrimidinyl, pyrrolyl, furanyl, or thiophenyl groups); wherein R^{7'} is hydrogen, a substituted or unsubstituted alkyl group having 1 to 12 carbon atoms (including both linear and branched alkyl groups), a substituted or unsubstituted aryl group, or a substituted or unsubstituted heteroaryl group;
A¹ and A² independently represent substituted or unsubstituted alkyl groups each having 1 to 12 carbon atoms (including both linear and branched alkyl groups), or together they represent the two or three carbon atoms necessary to form a substituted or unsubstituted 5-or 6-membered non-aromatic carbocyclic ring (such as substituted or unsubstituted cyclopentyl or cyclohexyl rings); and
Za represents one or more counter ions to balance the electric charge in the rest of the color-changing compound according to Formula (III) or Formula (IV).

When the rest of the (5) color-changing compound according to Formula (III) or Formula (IV) carries a positive charge, tetraarylborates such as tetraphenylborate and triarylalkylborates, such as triphenyl-n-butylborate, can be used as counter ions for Za.

Among the compounds represented by Formula (III), the compounds represented by the following Formula (V) are useful. 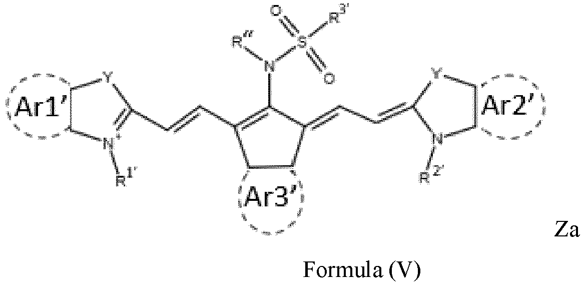 wherein Ar1', Ar^{2'}, Ar^{3'}, R^{1'}, R^{2'}, R^{3'}, R", Y, and Za are as defined above.

(5) Color-changing compounds represented by Formulae (III) and (IV) can produce color changes in the presence of a borate compound represented by the following Formula (VI):

[B(R^{10'}R^{11'}R^{12'}R^{13'})⁻]ₙ Mⁿ⁺ Formula (VI)

wherein R^{10'}, R^{11'}, R^{12'}, and R^{13'} are independently substituted or unsubstituted alkyl groups (each having 1 to 12 carbon atoms, including both linear and branched alkyl groups) or substituted or unsubstituted aryl groups (such as substituted or unsubstituted phenyl or naphthyl groups), and at least three of R^{10'}, R^{11'}, R^{12'}, and R^{13'} are the same or different, substituted or unsubstituted aryl groups (such as substituted or unsubstituted phenyl groups); Mⁿ⁺ is an n-valent cation and n is a positive integer. Among useful borate compounds represented by Formula (VI), a tetraphenyl borate salt is particularly useful. The borate anion of the borate compound can be incorporated as part of the free radical initiator composition (1) as noted above, or as a counterion in compounds represented by any of Formulae (I), (II), (III), (IV), and (V).

The (5) color-changing compound, singly or a mixture of two or more thereof, can be generally present in the infrared radiation-sensitive image-recording layer in an amount of at least 0.5 weight %, or at least 1 weight % and up to and including 10 weight % or up to and including 15 weight %, based on the total coverage (solids) of that infrared radiation-sensitive image-recording layer.

An optional but desirable component of the infrared radiation-sensitive image-recording layer is component (6) non-free radically polymerizable polymeric material (or polymeric binder), or a mixture of two or more thereof, each of which does not have any functional groups that, if present, would make the polymeric material capable of free radical polymerization. Thus, such component (6) non-free radically polymerizable polymeric material is different from all of components (1), (2), (3), (4), and (5) described above.

A useful component (6) non-free radically polymerizable polymeric material generally has a weight average molecular weight (M_{w}) of at least 2,000, or at least 20,000, and up to and including 300,000 or up to and including 500,000 g/mol, as determined by Gel Permeation Chromatography (polystyrene standard).

Such component (6) non-free radically polymerizable polymeric material can be selected from polymeric binder materials known in the art including polymers comprising recurring units having side chains comprising polyalkylene oxide segments such as those described in for example, U.S. Patent 6,899,994 (Huang et al.). Other useful polymeric binders comprise two or more types of recurring units having different side chains comprising polyalkylene oxide segments as described in for example WO Publication 2015-156065 (Kamiya et al.). Some of such polymeric binders can further comprise recurring units having pendant cyano groups as those described in for example U.S. Patent 7,261,998 (Hayashi et al.). Such component (6) non-free radically polymerizable materials also can have a backbone comprising multiple (at least two) urethane moieties as well as pendant groups comprising the polyalkylenes oxide segments.

Some useful component (6) non-free radically polymerizable polymeric materials can be present in particulate form, that is, in the form of discrete particles (non-agglomerated particles). Such discrete particles can have an average particle size of at least 10 nm and up to and including 1500 nm, or typically of at least 80 nm and up to and including 600 nm, and are generally distributed uniformly within the infrared radiation-sensitive image-recording layer. Average particle size can be determined using various known methods and nanoparticle measuring equipment, including measuring the particles in electron scanning microscope images and averaging a set number of measurements.

The component (6) non-free radically polymerizable polymeric material(s) can be present in an amount of at least 10 weight %, or at least 20 weight %, and up to and including 50 weight %, or up to and including 70 weight %, based on the total coverage (solids) of the infrared radiation-sensitive image-recording layer.

Other useful component (6) non-free radically polymerizable polymeric materials include water-soluble polymers such as various grades of hydroxy-propyl cellulose ether and various grades of polyvinyl alcohol having various saponification degrees and water-insoluble polymers such as linear or branched polymethylmethacrylate and other acrylic polymers, polyvinyl butyral and other polyvinyl polymers, polyurethane, polyester and polyurea. Examples of hydroxy-propyl celluloses include Klucel E (available from Ashland USA), Klucel M (Available from Ashland USA), Nisso HPC-L (available from Nippon Soda Co. Ltd, Japan), and Nisso HPC-SL (Nippon Soda Co. Ltd, Japan).

The infrared radiation-sensitive image-recording layer used in the present invention can also optionally include crosslinked polymer particles, such materials having an average particle size of at least 2 µm, or of at least 4 µm, and up to and including 20 µm as described for example in U.S. Patents 9,366,962 (Hayakawa et al.), 8,383,319 (Huang et al.), and 8,105,751 (Endo et al). Such crosslinked polymeric particles can be present only in the infrared radiation-sensitive image-recording layer, only in the hydrophilic protective layer when present (described below), or in both the infrared radiation-sensitive image-recording layer and the hydrophilic protective layer when present.

The infrared radiation-sensitive image-recording layer can also include one or more compounds, each of which is represented by the following Structure (P): 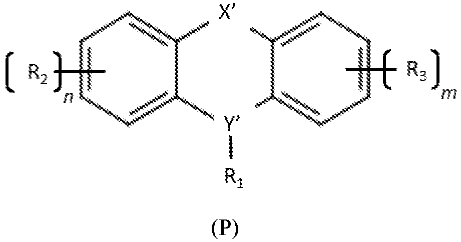 wherein in Structure (P):
X' is one of the divalent groups -O-, -S-, -NH-, or -CH₂-, and desirably, X is -S- or -NH-.
Y' is one or the trivalent groups >N- or >CH-, and desirably, it is >N-.
R₁ is hydrogen or a substituted or unsubstituted alkyl group, generally having from 1 to 20 carbon atoms in the unsubstituted form. When the alkyl group is substituted, it can have one or more substituents as allowed by its valence, as long as such substituents do not adversely affect providing a suitable, stable printout image as defined herein.
R₂ and R₃ are independently halo (fluoro, chloro, bromo, iodo), thioalkyl (that is, -S-alkyl, having 1 to 20 carbon atoms), thiophenyl (that is -S-phenyl), alkoxy (that is, -O-alkyl, having 1 to 20 carbon atoms), phenoxy (that is, -O-phenyl), alkyl (having 1 to 20 carbon atoms), phenyl, thioacetyl [that is, - C(=S)CH₃], or acetyl [that is, -C(=O)CH₃], groups. Where chemically possible, such groups can be substituted with one or more substituents as long as they do not adversely affect the provision of a suitable, stable printout image. It is particularly useful that R₂ and R₃ are independently a chloro, thioalkyl (having 1 or 2 carbon atoms), or acetyl, group.

Moreover, in Structure (P), m and n are independently 0 or an integer of from 1 to 4. Typically, m and n are independently 0, 1, or 2. Each of m and n can be zero; m can be zero and n can be 1 or 2; or m can be 1 and n can be 1 or 2.

Mixtures of two or more of these compounds represented by Structure (P) can be used if desired.

The one or more compounds, each represented by Structure (P) can be present in an amount that suitably effects optimal printout image and stability of that printout image. For example, the amount of such compounds can be at least 0.05 weight % and up to and including 5 weight %, based on the total dry weight of the infrared radiation-sensitive image-recording layer.

The infrared radiation-sensitive image-recording layer can also include a variety of other optional addenda including but not limited to, dispersing agents, humectants, biocides, plasticizers, surfactants for coatability or other properties, viscosity builders, pH adjusters, drying agents, defoamers, development aids, rheology modifiers, or combinations thereof, or any other addenda commonly used in the lithographic coating art, in conventional amounts. The infrared radiation-sensitive image-recording layer can also include a phosphate (meth)acrylate having a molecular weight generally greater than 250 as described in U.S. Patent 7,429,445 (Munnelly et al.).

Moreover, the infrared radiation-sensitive image-recording layer can optionally comprise one or more suitable chain transfer agents, antioxidants, or stabilizers to prevent or moderate undesired radical reactions.

### Hydrophilic Protective Laver:

While in some embodiments of the present invention, the infrared radiation-sensitive image-recording layer is the outermost layer with no layers disposed thereon, it is possible that the precursors according to this invention can be designed with a hydrophilic protective layer (also known in the art as a hydrophilic overcoat, oxygen-barrier layer, or topcoat) disposed directly on the infrared radiation-sensitive image-recording layer (with no intermediate layers between these two layers), especially if the imaged precursor is designed for off-press development (described below).

When present, this hydrophilic protective layer is generally the outermost layer of the precursor and thus, when multiple precursors are stacked one on top of the other, the hydrophilic protective layer of one precursor can be in contact with the backside of the substrate of the precursor immediately above it, where no interleaving paper is present.

Such hydrophilic protective layers can comprise one or more film-forming water-soluble polymeric binders in an amount of at least 60 weight % and up to and including 100 weight %, based on the total dry weight of the hydrophilic protective layer. Such film-forming water-soluble (or hydrophilic) polymeric binders can include a modified or unmodified poly(vinyl alcohol) having a saponification degree of at least 30%, or a degree of at least 75%, or a degree of at least 90%, and a degree of up to and including 99.9%.

Further, one or more acid-modified poly(vinyl alcohol)s can be used as film-forming water-soluble (or hydrophilic) polymeric binders in the hydrophilic protective layer. For example, at least one poly(vinyl alcohol) can be modified with an acid group selected from the group consisting of carboxylic acid, sulfonic acid, sulfuric acid ester, phosphonic acid, and phosphoric acid ester groups. Examples of useful modified poly(vinyl alcohol) materials include but are not limited to, sulfonic acid-modified poly(vinyl alcohol), carboxylic acid-modified poly(vinyl alcohol), and quaternary ammonium salt-modified poly(vinyl alcohol), glycol-modified poly(vinyl alcohol), or combinations thereof.

The optional hydrophilic overcoat can also include crosslinked polymer particles having an average particle size of at least 2 µm and as noted above.

When present, the hydrophilic protective layer is provided as a hydrophilic protective layer formulation and dried to provide a dry coating coverage of at least 0.1 g/m² and up to but less than 4 g/m², or typically at a dry coating coverage of at least 0.15 g/m² and up to and including 2.5 g/m². In some embodiments, the dry coating coverage is as low as 0.1 g/m² and up to and including 1.5 g/m² or at least 0.1 g/m² and up to and including 0.9 g/m², such that the hydrophilic protective layer is relatively thin for easy removal during off-press development or on-press development.

### Preparing Lithographic Printing Plate Precursors:

The lithographic printing plate precursors according to the present invention can be provided in the following manner. An infrared radiation-sensitive image-recording layer formulation comprising essential components (1), (2), (3), (4), and (5) and any optional addenda, described above, dissolved in a suitable solvent or a mixture of solvents, can be applied to a hydrophilic surface of a suitable aluminum-containing substrate, usually in the form of a continuous web, as described above, using any suitable equipment and procedure, such as knife coating, gravure coating, die coating, slot coating, bar coating, wire rod coating, roller coating, or extrusion hopper coating. Such formulation can also be applied by spraying onto a suitable substrate. Typically, once the infrared radiation-sensitive image-recording layer formulation is applied at a suitable wet coverage, it is dried in a suitable manner known in the art to provide a desired dry coverage as noted below, thereby providing an infrared radiation-sensitive continuous web or an infrared radiation-sensitive continuous article, which is then cut into rectangular sheets of proper sizes to form lithographic printing plate precursors suitable for making lithographic printing plates for use in lithographic printing. The components and addenda of the infrared radiation-sensitive image-recording layer can be designed such that upon imaging, this layer is readily removed on-press using either or a combination of a lithographic printing ink and a fountain solution.

As noted above, before the infrared radiation-sensitive image-recording layer formulation is applied, the substrate (that is, a continuous roll or web) can be electrochemically grained and anodized as described above to provide a suitable hydrophilic anodic (aluminum oxide) layer on the outer surface of the aluminum-containing support, and the anodized surface can be post-treated with a hydrophilic polymer solution as described above. The conditions and results of these operations are well known in the art as described above.

The manufacturing methods typically include mixing the various components needed for the infrared radiation-sensitive image-recording layer in a suitable organic solvent or mixtures thereof with or without water [such as methyl ethyl ketone (2-butanone), methanol, ethanol, 1-methoxy-2-propanol, 2-methoxypropanol, iso-propyl alcohol, acetone, γ-butyrolactone, n-propanol, tetrahydrofuran, and others readily known in the art, as well as mixtures thereof], applying the resulting infrared radiation-sensitive image-recording layer formulation to a continuous substrate web, and removing the solvent(s) by evaporation under suitable drying conditions.

After proper drying, the dry coverage of the infrared radiation-sensitive image-recording layer on the substrate can be at least 0.1 g/m², or at least 0.4 g/m², and up to and including 2 g/m² or up to and including 4 g/m² but other dry coverage amounts can be used if desired, to provide a desired dry coverage.

As described above, in some embodiments, a suitable aqueous-based hydrophilic protective layer formulation (described above) can be applied to the dried infrared radiation-sensitive image-recording layer using known coating and drying conditions, equipment, and procedures.

In practical manufacturing conditions, the result of these coating operations is a continuous radiation-sensitive web (or roll) of infrared radiation-sensitive lithographic printing plate precursor material having either only an infrared radiation-sensitive image-recording layer or both an infrared radiation-sensitive image-recording layer and a hydrophilic protective layer disposed as the outermost layer. Such continuous radiation-sensitive web can be slit or cut into appropriately sized precursors for use.

### Imaging (Exposing) Conditions

During use, an infrared radiation-sensitive lithographic printing plate precursor of this invention can be exposed to a suitable source of infrared radiation depending upon the infrared radiation absorber(s) present in the infrared radiation-sensitive image-recording layer. In some embodiments, the lithographic printing plate precursors can be imaged with one or more infrared radiation-emitting lasers that emit significant infrared radiation (including near-IR radiation) within the range of at least 750 nm and up to and including 1400 nm, or of at least 800 nm and up to and including 1250 nm to create exposed regions and non-exposed regions in the infrared radiation-sensitive image-recording layer. Such infrared radiation-emitting lasers can be used for such imaging in response to digital information supplied by a computing device or other source of digital information. The laser imaging can be digitally controlled in a suitable manner known in the art.

Thus, imaging can be carried out using imaging or exposing infrared radiation from an infrared radiation-generating laser (or array of such lasers). Imaging also can be carried out using imaging radiation at multiple infrared (or near-IR) wavelengths at the same time if desired. The laser(s) used to expose the precursor is usually a diode laser(s), because of the reliability and low maintenance of diode laser systems, but other lasers such as gas or solid-state lasers can also be used. The combination of power, intensity, and exposure time for infrared radiation imaging would be readily apparent to one skilled in the art.

The infrared imaging apparatus can be configured as a flatbed recorder or as a drum recorder, with the infrared radiation-sensitive lithographic printing plate precursor mounted to the interior or exterior cylindrical surface of the drum. An example of useful imaging apparatus is available as models of KODAK^{®} Trendsetter platesetters (Eastman Kodak Company) and NEC AMZISetter X-series (NEC Corporation, Japan) that contain laser diodes that emit radiation at a wavelength of 830 nm. Other suitable imaging apparatus includes the Screen PlateRite 4300 series or 8600 series platesetters (available from Screen USA, Chicago, IL) or thermal CTP platesetters from Panasonic Corporation (Japan) that operates at a wavelength of 810 nm.

It can be desirable to include a means for reducing or removing ozone in the environment of the laser imaging if the infrared radiation-sensitive image-recording layer is sensitive to the presence of ozone. Useful means and system for doing this is described for example in U.S. Patent Application Publication 2019/0022995 (Igarashi et al.).

When an infrared radiation imaging source is used, imaging energy intensities can be at least 30 mJ/cm² and up to and including 500 mJ/cm² and typically at least 50 mJ/cm² and up to and including 300 mJ/cm² depending upon the sensitivity of the infrared radiation-sensitive image-recording layer. For high productivity in the plate-making process, the infrared radiation energy intensities are generally at or below 150 mJ/cm², or at or below 120 mJ/cm², or even at or below 90 mJ/cm².

### Processing (Development) and Printing

After imagewise exposing as described above, the exposed infrared radiation-sensitive lithographic printing plate precursors having infrared radiation exposed regions and infrared radiation non-exposed regions in the infrared radiation-sensitive image-recording layer can be processed off-press or on-press to remove the infrared radiation non-exposed regions (and any hydrophilic protective layer over such regions). After this processing, and during lithographic printing, the revealed hydrophilic substrate surface repels inks while the remaining infrared radiation exposed regions accept lithographic printing ink.

### Off-Press Development and Printing:

Processing can be carried out off-press using any suitable developer in one or more successive applications (treatments or developing steps) of the same or different processing solution (developer). Such one or more successive processing treatments can be carried out for a time sufficient to remove the infrared radiation non-exposed regions of the infrared radiation-sensitive image-recording layer to reveal the outermost hydrophilic surface of the substrate, but not long enough to remove significant amounts of the infrared radiation exposed regions that have been hardened in the same layer.

Prior to such off-press processing, the exposed precursors can be subjected to a "pre-heating" process to further harden the infrared radiation exposed regions in the infrared radiation-sensitive image-recording layer. Such optional pre-heating can be carried out using any known process and equipment generally at a temperature of at least 60°C and up to and including 180°C.

Following this optional pre-heating, or in place of the pre-heating, the exposed precursor can be washed (rinsed) to remove any hydrophilic overcoat that is present. Such optional washing (or rinsing) can be carried out using any suitable aqueous solution (such as water or an aqueous solution of a surfactant) at a suitable temperature and for a suitable time that would be readily apparent to one skilled in the art.

Useful developers can be ordinary water or formulated aqueous solutions. The formulated developers can comprise one or more components selected from surfactants, organic solvents, alkali agents, and surface protective agents. For example, useful organic solvents include the reaction products of phenol with ethylene oxide and propylene oxide [such as ethylene glycol phenyl ether (phenoxyethanol)], benzyl alcohol, esters of ethylene glycol and of propylene glycol with acids having 6 or less carbon atoms, and ethers of ethylene glycol, diethylene glycol, and of propylene glycol with alkyl groups having 6 or less carbon atoms, such as 2-ethylethanol and 2-butoxyethanol.

In some instances, an aqueous processing solution can be used off-press to both develop the imaged precursor by removing the infrared radiation non-exposed regions and also to provide a protective layer or coating over the entire imaged and developed (processed) precursor printing surface. In this embodiment the aqueous solution behaves somewhat like a gum that is capable of protecting (or "gumming") the lithographic image on the lithographic printing plate against contamination or damage (for example, from oxidation, fingerprints, dust, or scratches).

After the described off-press processing and optional drying, the resulting lithographic printing plate can be mounted onto a printing press without any contact with additional solutions or liquids. It is optional to further bake the lithographic printing plate with or without blanket or flood-wise exposure to UV or visible radiation.

Printing can be carried out by applying a lithographic printing ink and fountain solution to the printing surface of the lithographic printing plate in a suitable manner. The fountain solution is taken up by the hydrophilic surface of the substrate revealed by the exposing and processing steps, and the lithographic ink is taken up by the remaining (exposed) regions of the infrared radiation-sensitive image-recording layer. The lithographic ink is then transferred to a suitable receiving material (such as cloth, paper, metal, glass, or plastic) to provide a desired impression of the image thereon. If desired, an intermediate "blanket" roller can be used to transfer the lithographic ink from the lithographic printing plate to the receiving material (for example, sheets of paper).

### On-Press Development and Printing:

Alternatively, the lithographic printing plate precursors of the present invention are on-press developable using a lithographic printing ink, a fountain solution, or a combination of a lithographic printing ink and a fountain solution. In such embodiments, an imaged (infrared radiation exposed) infrared radiation-sensitive lithographic printing plate precursor according to the present invention is mounted onto a printing press and the printing operation is begun. The infrared radiation non-exposed regions in the infrared radiation-sensitive image-recording layer are removed by a suitable fountain solution, lithographic printing ink, or a combination of both, when the initial printed impressions are made. Typical ingredients of aqueous fountain solutions include pH buffers, desensitizing agents, surfactants and wetting agents, humectants, low boiling solvents, biocides, antifoaming agents, and sequestering agents. A representative example of a fountain solution is Varn Litho Etch 142W + Varn PAR (alcohol sub) (available from Varn International, Addison, IL).

In a typical printing press startup with a sheet-fed printing machine, the dampening roller is engaged first and supplies fountain solution to the mounted imaged precursor to swell the exposed infrared radiation-sensitive image-recording layer at least in the infrared radiation non-exposed regions. After a few revolutions the inking rollers are engaged and they supply lithographic printing ink(s) to cover the entire printing surface of the lithographic printing plates. Typically, within 5 to 20 revolutions after the inking roller engagement, printing sheets are supplied to remove the infrared radiation non-exposed regions of the infrared radiation-sensitive image-recording layer from the lithographic printing plate as well as materials on a blanket cylinder if present, using the formed ink-fountain solution emulsion.

On-press developability of infrared radiation exposed lithographic printing precursors is particularly useful when the precursor comprises one or more polymeric binder materials (whether free radically polymerizable or not) in an infrared radiation-sensitive image-recording layer, at least one of which polymeric binders is present as particles having an average diameter of at least 50 nm and up to and including 400 nm.

The following examples are provided to further illustrate the practice of the present invention and are not meant to be limiting in any manner. Unless otherwise indicated, the materials used in the examples were obtained from various commercial sources as indicated but other commercial sources may be available.

An aluminum-containing substrate was prepared for the lithographic printing plate precursors in the following manner:
Hydro 1052 aluminum alloy strip or web (available from Norsk Hydro ASA, Norway) having a thickness of 0.28 mm was used as the aluminum-containing "plate" stock or support. Both pre-etch and post-etch steps were carried out in alkaline solutions under known conditions. Roughening (or graining) of the etched aluminum support was carried out by electrochemical means in a hydrochloric acid solution at 23°C to obtain an arithmetic average roughness (Ra) of 0.4 µm on a surface of the aluminum-containing support. Thereafter, the aluminum-containing supports were subjected to a single anodizing treatment using phosphoric acid as the electrolyte to form an aluminum oxide layer of 1.1 g/m². The anodizing step was carried out in a continuous process on a typical manufacturing line used to manufacture lithographic printing plate precursors. The aluminum-containing support thus prepared was then coated with an aqueous solution of polyacrylic acid to give a dry thickness of 0.03 g/m² for a substrate useful in the present invention.

A negative-working, infrared radiation-sensitive image-recording layer was then formed on the aluminum-containing substrate as described by individually coating infrared radiation-sensitive composition formulations having the components and amounts shown in the following TABLES I and II using a bar coater, to provide a dry coating weight of 0.9 g/m² after drying at 50°C for 60 seconds for each of the inventive and comparative precursors described below. The raw materials noted in TABLE I are identified in the following TABLE II. For each of the acid-sensitive color-changing compounds (ASCC) listed in TABLE II, the peak(s) absorption electromagnetic wavelengths (λₘₐₓ) are also provided, and an estimation of their absorbance, as received by the measurement of spectral densities of the image vs. non-image at a wavelength of 620 nm by a Techkon SpectroDens, in the following TABLE III.

These materials can be obtained from one or more commercial sources of chemicals or prepared using known synthetic methods and starting materials.

**TABLE I**

| **Component** | **Amount (grams)** |
|---|---|
| Polymer dispersion | 0.684 |
| Hydroxypropyl methyl cellulose | 0.400 |
| Monomer 1 (free radical polymerizable component) | 0.333 |
| Monomer 2 (free radical polymerizable component) | 0.167 |
| IR dye 1 (infrared radiation absorber) | 0.020 |
| Acid-sensitive color-changing compound identified as ASCC in TABLE III | 0.023 |
| Color Changing Compound identified as CCC in TABLE III | 0.020 |
| Surfactant 1 | 0.045 |
| Iodonium salt | 0.060 |
| Compound P1 | 0.0050 |
| 1-Propanol | 3.31 |
| 2-Butanone | 1.80 |
| 1-Methoxy-2-propanol | 2.62 |
| δ-Butyrolactone | 0.10 |
| Water | 0.44 |

**TABLE II**

| | |
|---|---|
| Polymer dispersion | The polymer dispersion was prepared according to Example 10 of EP 1,765,593, used as 23.5 weight % polymer in *n-*propanol/water at 80:20 weight ratio |
| Hydroxypropyl methyl cellulose | 5 weight % hydroxypropyl methyl cellulose polymer in water; the polymer is 30% methoxylated, 10% hydroxyl propoxylated and had a viscosity of 5 mPa-sec in a 2 weight % aqueous solution at 20°C |
| Monomer 1 | Urethane acrylate prepared by reacting DESMODUR^{®} N100 (from Bayer Corp., Milford, CT) with hydroxyethyl acrylate and pentaerythritol triacrylate at approximately 1:1.5:1.5 molar ratio (40 weight % in 2-butanone). |
| Monomer 2 | Ethoxylated (10 EO) Bisphenol A diacrylate, 40 weight % in 2-butanone |
| IR dye 1 | 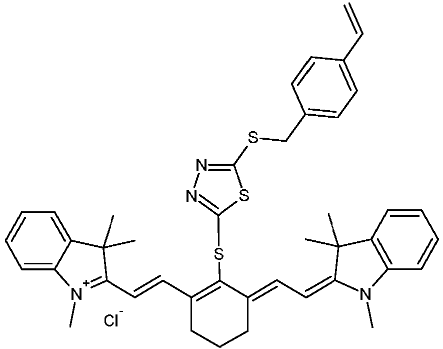 |
| Surfactant 1 | BYK^{®} 302 from Byk Chemie, used as a 25 weight % solution in 1-methoxy-2-propanol |
| Iodonium Salt | 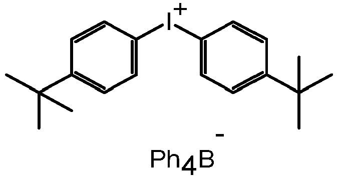 |
| Compound P1 | 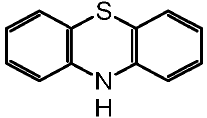 |
| Inventive ASCC 1 | 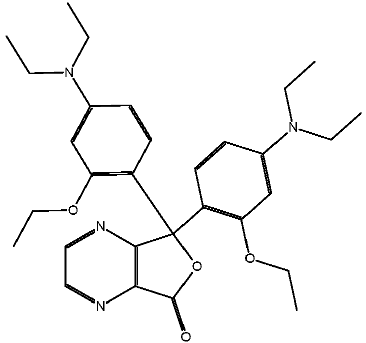 color forming λₘₐₓ = 646 nm |
| Inventive ASCC 2 | 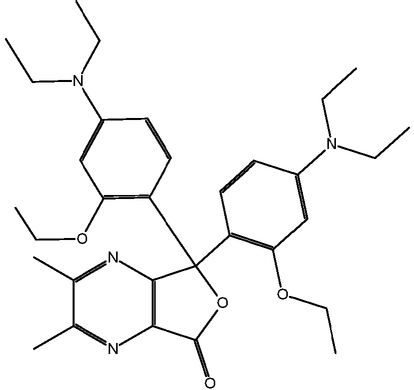 color forming λₘₐₓ = 634 nm |
| Inventive ASCC 3 | 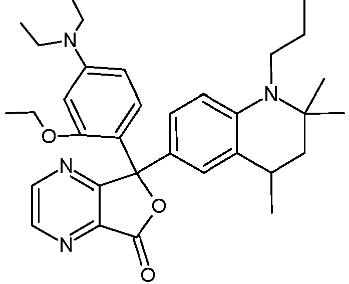 color forming λₘₐₓ = 656 nm |
| Inventive ASCC 4 | 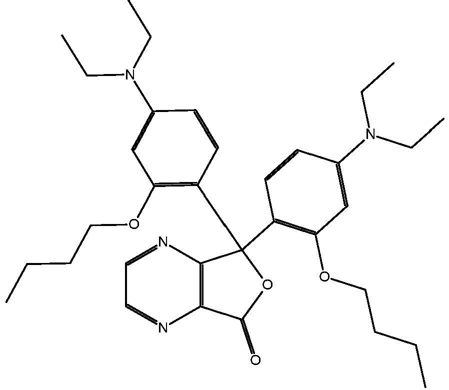 color forming λₘₐₓ = 648 nm |
| Inventive ASCC 5 | 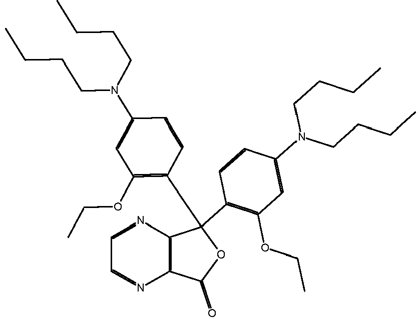 color forming λₘₐₓ = 650 nm |
| Comparative ASCC 1 | 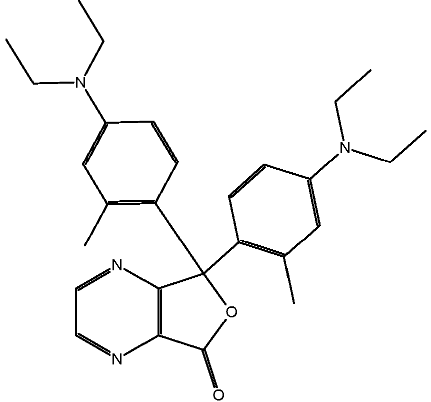 color forming λₘₐₓ = 688 nm |
| Comparative ASCC 2 | 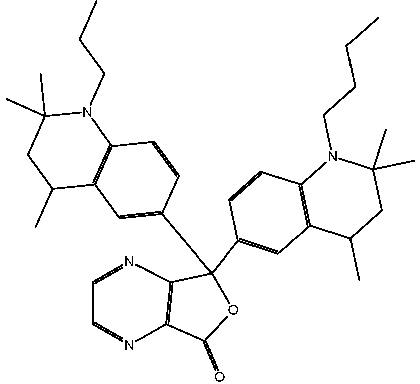 color forming λₘₐₓ = 672 nm |
| Comparative ASCC 3 | 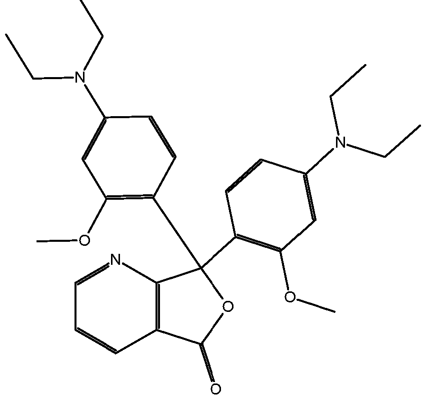 color forming λₘₐₓ = 636 nm |
| Comparative ASCC 4 | 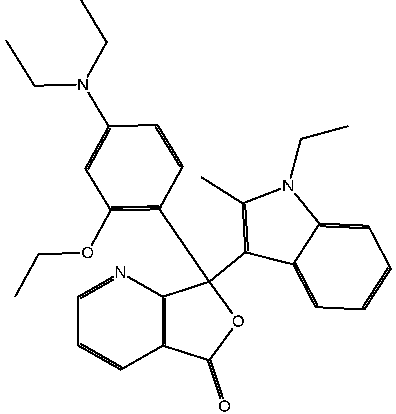 color forming λₘₐₓ = 580 nm |
| Comparative ASCC 5 | 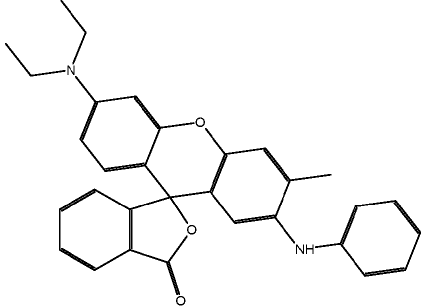 color forming λₘₐₓ = 450/580 nm |
| Comparative ASCC 6 | 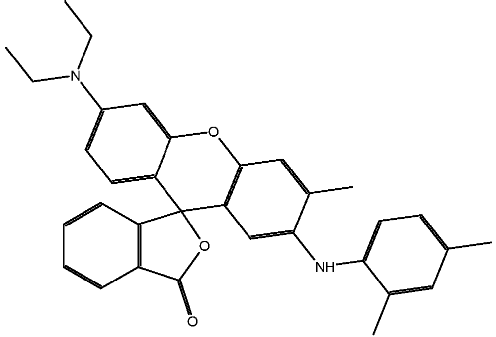 color forming λₘₐₓ = 450/580 nm |
| Comparative ASCC 7 | 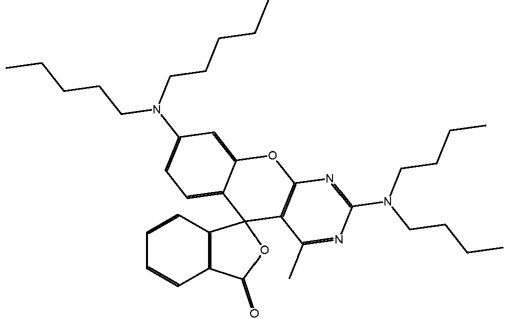 color forming λₘₐₓ = 540 nm |
| CCC1 | 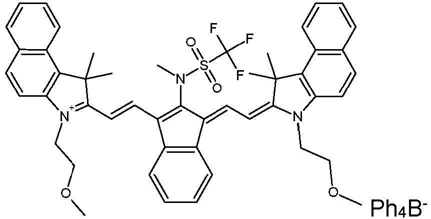 |
| CCC2 | 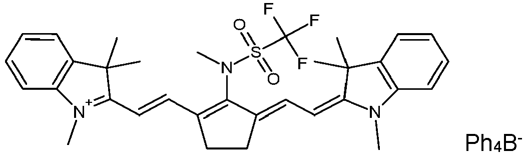 |

The color forming λₘₐₓ values of acid-sensitive color-changing compounds noted in the previous TABLE II (that is, the Inventive ASCC and Comparative ASCC compounds) were measured in a methanol solution containing 1 eq HCl relative to the amount of the acid-sensitive color-changing compounds.

Each of the inventive and comparative lithographic printing plate precursors (or resulting lithographic printing plates) was evaluated using five tests: "on-press developability" (DOP), "photospeed", "printout ΔOD_{cyan}", "dark fading of Printout ΔOD_{cyan}", and "camera readability" The results are summarized below in TABLE III.

Each precursor was imagewise exposed on a commercially available Kodak Trendsetter 3244x image setter at an imaging energy of 15-150 mJ/cm² and thus an imagewise exposed lithographic printing plate precursor was formed, having infrared radiation exposed regions and infrared radiation non-exposed regions.

### On-press Developability (DOP):

On-press developability was evaluated by mounting each imagewise infrared radiation exposed lithographic printing plate precursor onto a MAN Roland Favorite 04 press machine without separate off-press developing (processing). Fountain solution (Vam Supreme 6038) and lithographic printing ink (Gans Cyan) were supplied, and lithographic printing was performed. On-press development occurred during printing and was evaluated by counting the number of printed paper sheets needed to receive a clean background, and each precursor was given one of the following qualitative values based on the number of printed paper sheets to achieve a clean background. The + and 0 evaluations are acceptable for this test parameter.

| | |
|---|---|
| + | < 5 printing paper sheets |
| 0 | 5-15 printed paper sheets |
| - | > 15 printed paper sheets |

### Photospeed:

Printing press life was estimated by determining the photospeed of each of the infrared radiation exposed lithographic printing plate precursors. The precursors were infrared radiation exposed and developed on-press as described above. Photospeed was measured on impressions on paper after 1000 impressions by a determination of ink density for solid areas that had been exposed to different infrared radiation energies. The inflection point of ink density vs. exposure energy is regarded as a measure for imaging speed. The following qualitative values were given as the results of the individual experiments, with lower imaging energy desirable. The + and 0 evaluations are acceptable for this parameter.

| | |
|---|---|
| + | photospeed < 20 mJ/cm² |
| 0 | photospeed = 20 to 50 mJ/cm² |
| - | photospeed > 50 mJ/cm² |

### Printout ΔOD_{cyan}:

Each of the lithographic printing plate precursors was imagewise exposed as described above at 90 mJ/cm² to provide infrared radiation exposed regions and infrared radiation non-exposed regions in the negative-working, IR-sensitive image-recording layer. For each imagewise exposed lithographic printing plate precursor, the color difference between infrared radiation exposed regions and infrared radiation non-exposed regions was measured using a Techkon Spectro Dens spectral densitometer, and calculating the Euclidean distance of the measured L*, a*, and b* chromaticity values. The cyan ΔOD represents the difference in reflective optical density observed through a cyan filter between the infrared radiation exposed and infrared radiation non-exposed regions. The visual images on a lithographic printing plate precursor with a high cyan ΔOD absolute value are expected to be more readable by cameras and other reading devices that are built with a diode light source emitting around 620 - 640 nm light. The measured values were scored for each precursor as follows.

| | |
|---|---|
| + | ΔOD_{cyan} > 0.200 |
| 0 | 0.1 ≤ ΔOD_{cyan} ≤ 0.200 |
| - | ΔOD_{cyan} < 0.100 |

### Dark fading of Printout ΔOD_{cyan}:

Each of the infrared radiation-sensitive precursor was imagewise exposed to infrared radiation as described above and stored in the dark at ambient conditions. Evaluation was performed as described above for ΔOD_{cyan}, but 24 hours after imaging (ΔOD_{cyan. 24h}). Fading of visual images was rated relatively to the initial ΔOD_{cyan} (ΔOD_{cyan 0h}) were measured immediately after imaging. The measured values were scored for each precursor as follows:

| | |
|---|---|
| + | ΔOD_{cyan, 24h} / ΔOD_{cyan, 0h} ≥ 0.90 |
| 0 | 0.90 > ΔOD_{cyan, 24h} / ΔOD_{cyan, 0h} > 0.80 |
| - | ΔOD_{cyan, 24h} / ΔOD_{cyan, 0h} ≤ 0.80 |

### Camera Readability:

Each of the lithographic printing plate precursors was imagewise exposed at 90 mJ/cm² as described above. For a general assessment of the camera readability with the most common devices, absorbance spectra of the precursors in the imaged areas (areas exposed by infrared radiation laser) and the infrared radiation non-imaged areas (areas not exposed by infrared radiation laser) were recorded using a Techkon SpektroDens spectrophotometer in a reflective mode. For each precursor, the absorbance values at 620 nm were read from the absorbance spectra of an infrared radiation exposed region and an infrared radiation non-exposed region and the differences, Δ absorbance at 620 nm, were used to rate the camera readability according to the following scoring criteria. A "0" score denotes acceptable camera readability, a "+" score denotes superior camera readability and a "-" score denotes poor camera readability.

| | |
|---|---|
| + | Δ absorbance at 620nm > 0.050 |
| 0 | 0.050 ≥ Δ absorbance at 620nm ≥ 0.030 |
| - | Δ absorbance at 620nm < 0.030 |

The results of the noted evaluations of the precursors is provided in the following TABLE III.

**TABLE III**

| **Example** | **ASCC** | **CCC** | **Camera readability** | **DOP** | **Photo speed** | **Printout ΔOD_{cyan}** | **Dark fading of Printout ΔOD_{cyan}** |
|---|---|---|---|---|---|---|---|
| Inventive 1 | Inventive ASCC1 | CCC1 | + | 0 | 0 | + | + |
| Inventive 2 | Inventive ASCC2 | CCC1 | 0 | 0 | 0 | 0 | + |
| Inventive 3 | Inventive ASCC3 | CCC1 | 0 | 0 | 0 | 0 | + |
| Inventive 4 | Inventive ASCC4 | CCC1 | + | 0 | 0 | + | + |
| Inventive 5 | Inventive ASCC5 | CCC1 | + | 0 | 0 | + | 0 |
| Inventive 6 | Inventive ASCC1 | CCC2 | + | 0 | 0 | + | 0 |
| Inventive 7 | Inventive ASCC3 | CCC2 | 0 | 0 | 0 | 0 | + |

**TABLE III - continued**

| | | | | | | | |
|---|---|---|---|---|---|---|---|
| Comparative 1 | comp. ASCC1 | CCC1 | - | 0 | 0 | - | + |
| Comparative 2 | comp. ASCC2 | CCC1 | - | 0 | 0 | 0 | + |
| Comparative 3 | comp. ASCC3 | CCC1 | - | 0 | 0 | 0 | - |
| Comparative 4 | comp. ASCC4 | CCC1 | - | 0 | 0 | - | - |
| Comparative 5 | comp. ASCC5 | CCC1 | - | 0 | 0 | 0 | 0 |
| Comparative 6 | comp. ASCC6 | CCC1 | - | 0 | 0 | 0 | 0 |
| Comparative 7 | comp. ASCC7 | CCC1 | - | 0 | 0 | - | + |

| | | | | | | | |
|---|---|---|---|---|---|---|---|
| Note: "comp." in Table III is an abbreviation for the word "Comparative". | | | | | | | |

The results shown above in TABLE III demonstrate that the use of the (3) acid-sensitive color-changing compounds Inventive ASCC1 to ASCC5 according to the present invention provided better results than the comparative acid-sensitive color-changing compounds Comparatives ASCC1 to ASCC7 that are outside the scope of the present invention, in view of printout formation and printout stability after storage in the dark without compromising other printing plate or precursor parameters such as on-press developability or photospeed. These results were achieved irrespective of the substituents at positions R³, R⁴, and R⁵ of Formula (I), as demonstrated here. The exposed precursor of Inventive Example 2 where the (3) acid-sensitive color-changing compound (Inventive ASCC2) having methyl groups as R¹ and R² in Formula (I) exhibited slightly less strong printout formation and fading but the printout was still much stronger than observed for the comparative examples. The data from Inventive Example 3 using Inventive ASCC3 as the (3) acid-sensitive color-changing compound demonstrated that one group according to the invention (aromatic group with an amino group *in para* position and an alkoxy group in *ortho* position) is sufficient to achieve the desired effect, even though two aromatic groups according to this structure are possible and easier to prepare from a synthetic point of view.

The data from Comparative Example 3 also showed that an absorbance maximum (that is an absorption peak) close to the desired wavelength does not provide sufficient contrast if the absorbance at the specific wavelength remains low.

The data from Inventive Example 1 vs. Comparative Example 1 showed the criticality of the alkoxy group OR³ in Formula (I) as a decrease of absorbance and a loss of desired contrast will occur if this structural element is missing. The data from Inventive Example 1 vs. Comparative Example 3 demonstrates the importance of the pyrazine structure itself in Formula (I) as the lack of the second nitrogen in the heteroaromatic ring will result in decreased absorbance.

## Claims

1. A lithographic printing plate precursor comprising:
a substrate, and
an infrared radiation-sensitive image-recording layer disposed on the substrate, the infrared radiation-sensitive image-recording layer comprising the following components (1), (2), (3), (4), and (5):
(1) a free radical initiator composition that is capable of generating free radicals upon exposure to infrared radiation and comprises a borate compound;
(2) a free radically polymerizable composition;
(3) an acid-sensitive color-changing compound that is represented by the following Formula (I): 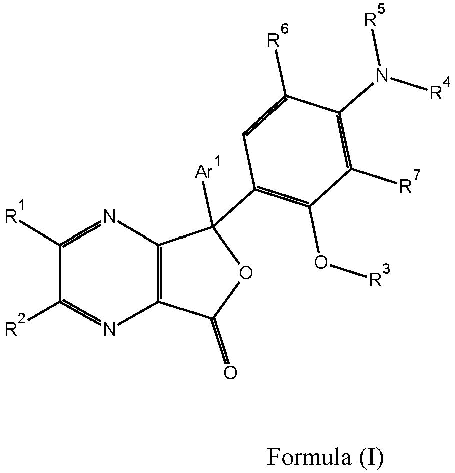 wherein:
Ar¹ is a substituted or unsubstituted aryl or a substituted or unsubstituted heteroaryl group;
R¹and R² are independently hydrogen, substituted or unsubstituted alkyl groups, each having 1 to 12 carbon atoms, substituted or unsubstituted aryl groups, or substituted or unsubstituted heteroaromatic groups, or R¹ and R² can be connected to form a fused ring;
R³ is a substituted or unsubstituted alkyl group having 1 to 12 carbons, a substituted or unsubstituted aryl, or a substituted or unsubstituted heteroaryl group;
R⁴ and R⁵ are independently hydrogen, substituted or unsubstituted alkyl groups, each having 1 to 12 carbon atoms, substituted or unsubstituted aryl groups, or substituted or unsubstituted heteroaromatic groups; and
R⁶ and R⁷ are independently hydrogen, or substituted or unsubstituted alkyl groups having 1 to 12 carbons,
or R⁴ and R⁶ can be linked together to form a cyclic structure, or R⁵ and R⁷ can be linked together to form a cyclic structure, or either or both of R⁴ and R⁵ can be linked to R⁶ and R⁷, respectively;
(4) an infrared absorbing material; and
(5) a color-changing compound represented by either Formula (III) or Formula (IV): 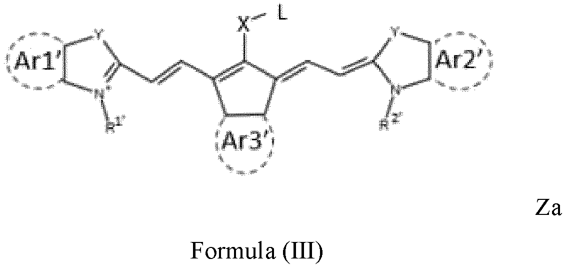 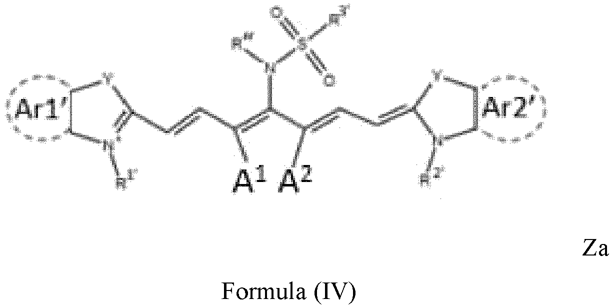 wherein:
Ar1', Ar2', and Ar3' independently represent the atoms necessary to complete substituted or unsubstituted aromatic rings or to complete substituted or unsubstituted heteroaromatic rings;
Y represents an oxygen atom, a sulfur atom, or a dialkylmethylene group represented by >C(R^{4'}R^{5'}) wherein R^{4'} and R^{5'} are independently substituted or unsubstituted alkyl groups, each having 1 to 4 carbons;
R" is hydrogen, a substituted or unsubstituted alkyl group, a substituted or unsubstituted aryl group, or a substituted or unsubstituted heteroaryl group;
R^{1'} and R^{2'} are independently substituted or unsubstituted alkyl groups;
X represents a single bond or a divalent linking group selected from -S-, -O-, and >N(R^{6'}) wherein R^{6'} is hydrogen, a substituted or unsubstituted alkyl group, a substituted or unsubstituted aryl group, a substituted or unsubstituted heteroaryl group, or L;
L represents a -C(=O)-OR^{7'} group, -SO₂-R^{3'} group, or -SO₂NR^{8'}R^{9'} group, wherein R^{7'} represents a substituted or unsubstituted alkyl group that has a secondary or tertiary connecting carbon that connects to the remainder of the -C(=O)OR^{7'} group; and R^{3'}, R^{8'}, and R^{9'} independently represent substituted or unsubstituted alkyl groups, substituted or unsubstituted aryl groups, or substituted or unsubstituted heteroaryl groups; R^{7'} is hydrogen, a substituted or unsubstituted alkyl group, a substituted or unsubstituted aryl group, or a substituted or unsubstituted heteroaryl group;
A¹ and A² independently represent substituted or unsubstituted alkyl groups, or together they represent the two or three carbon atoms necessary to form a substituted or unsubstituted 5- or 6-membered non-aromatic carbocyclic ring; and
Za represents one or more counter ions to balance the electric charge in the rest of the color-changing compound according to Formula (III) or Formula (IV), and
wherein the borate compound is represented by the following Formula (VI):
[B(R^{10'}R^{11'}R^{12'}R^{13'})⁻]ₙ Mⁿ⁺ Formula (VI)
wherein R^{10'}, R^{11'}, R^{12'}, and R^{13'} are independently substituted or unsubstituted alkyl groups or substituted or unsubstituted aryl groups, and at least three of R^{10'}, R^{11'}, R^{12'}, and R^{13'} are substituted or unsubstituted aryl groups; Mⁿ⁺ is an n-valent cation and n is a positive integer;
wherein infrared radiation is a radiation having a wavelength of at least 750 nm and higher.

2. The lithographic printing plate precursor of claim 1, wherein R³ is a substituted or unsubstituted alkyl group having 1 to 6 carbon atoms.

3. The lithographic printing plate precursor of claim 1 or 2,
wherein R⁴ and R⁵ are independently substituted or unsubstituted alkyl groups, each having 1 to 6 carbon atoms.

4. The lithographic printing plate precursor of any of claims 1 to 3, wherein Ar¹ is one of the following groups: 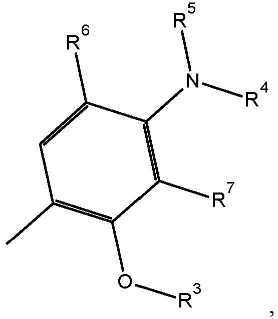 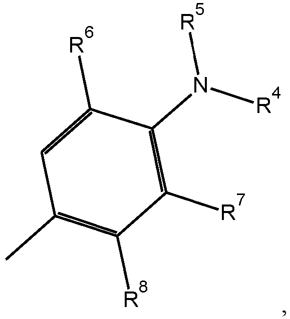 and 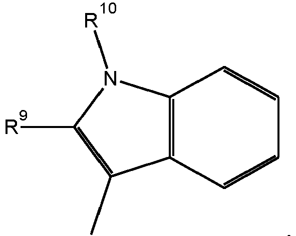 wherein R³, R⁴, R⁵, R⁶, and R⁷ are as defined above, and R⁸, R⁹, and R¹⁰ are independently hydrogen, or substituted or unsubstituted alkyl groups, each having 1 to 12 carbon atoms.

5. The lithographic printing plate precursor of any of claims 1 to 4, wherein the component (3) acid-sensitive color-changing compound is represented by Formula (II) 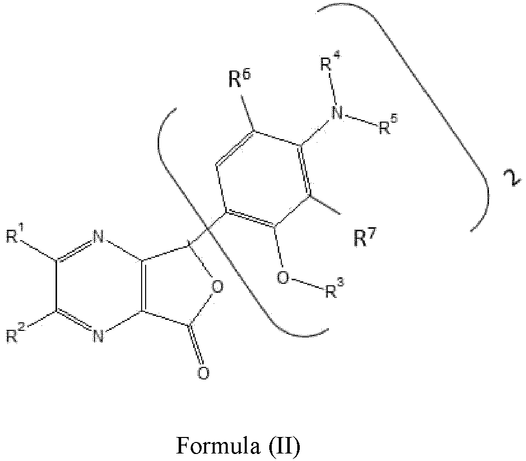 wherein R¹ through R⁷ have the same meanings as for Formula (I).

6. The lithographic printing plate precursor of any of claims 1 to 5, wherein the component (1) free radical initiator composition comprises a diaryliodonium cation.

7. The lithographic printing plate precursor of any of claims 1 to 6, wherein the borate compound comprises a tetraphenylborate anion.

8. The lithographic printing plate precursor of any of claims 1 to 7, wherein the infrared radiation-sensitive image-recording layer further comprises a component (6) non-free radically polymerizable polymeric material that is different from all of the components (1), (2), (3), and (4) defined above.

9. The lithographic printing plate precursor of any of claims 1 to 8, wherein the component (3) acid-sensitive color-changing compound represented by Formula (I) is present in the infrared radiation-sensitive image-recording layer in a dry coverage amount of at least 0.5 weight % and up to and including 15 weight %, based on the total dry coverage of the infrared radiation-sensitive image-recording layer.

10. The lithographic printing plate precursor of any of claims 1 to 9, wherein the infrared radiation-sensitive image-recording layer is the outermost layer.

11. The lithographic printing plate precursor of any of claims 1 to 10, wherein the infrared radiation-sensitive image-recording layer further comprises one or more compounds, each of which is represented by the following Structure (P): 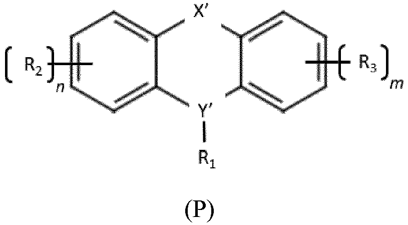 wherein in Structure (P):
X' is one of the divalent groups -O-, -S-, -NH-, or -CH₂-;
Y' is one of the trivalent groups >N- or >CH-;
R₁ is hydrogen or a substituted or unsubstituted alkyl group;
R₂ and R₃ are independently halo, thioalkyl, thiophenyl, alkoxy, phenoxy, alkyl, phenyl, thioacetyl, or acetyl groups; and
m and n are independently 0 or an integer of from 1 to 4.

12. The lithographic printing plate precursor of any of claims 1 to 11, wherein the substrate comprises an aluminum-containing substrate comprising at least an inner aluminum oxide layer, an outer aluminum oxide layer disposed on the inner aluminum oxide layer, and a hydrophilic polymer coating that is disposed on the outer aluminum oxide layer.

13. A method for providing a lithographic printing plate, comprising:
A) imagewise exposing the lithographic printing plate precursor according to any of claims 1 to 12 to infrared radiation, to provide infrared radiation exposed regions and infrared radiation non-exposed regions in the infrared radiation-sensitive image-recording layer, and
B) removing the infrared radiation non-exposed regions in the infrared radiation-sensitive image-recording layer from the substrate;
wherein infrared radiation is a radiation having a wavelength of at least 750 nm and higher.

14. The method of claim 13, comprising removing the infrared radiation non-exposed regions in the infrared radiation-sensitive image-recording layer from the substrate on-press using a lithographic printing ink, a fountain solution, or a combination of a lithographic printing ink and a fountain solution.

15. The method of claim 13 or 14, wherein the difference in reflective absorbance between infrared radiation exposed regions and infrared radiation non-exposed regions in the infrared radiation-sensitive image-recording layer immediately after step (A) is at least 0.02, and/or step (A) is carried out at or below 120 mJ/cm² infrared radiation energy.

## Patentansprüche

1. Ein Lithographiedruckplattenvorläufer, umfassend:
ein Substrat, und
eine infrarotstrahlungsempfindliche Bildaufzeichnungsschicht, angeordnet auf dem Substrat, wobei die infrarotstrahlungsempfindliche Bildaufzeichnungsschicht die folgenden Komponenten (1), (2), (3), (4) und (5) umfasst:
(1) eine radikalische Initiatorzusammensetzung, die in der Lage ist, freie Radikale zu erzeugen, wenn sie Infrarotstrahlung ausgesetzt wird und eine Boratverbindung umfasst;
(2) eine radikalisch polymerisierbare Zusammensetzung;
(3) eine säureempfindliche farbverändernde Verbindung, welche durch die folgende Formel (I) dargestellt ist: 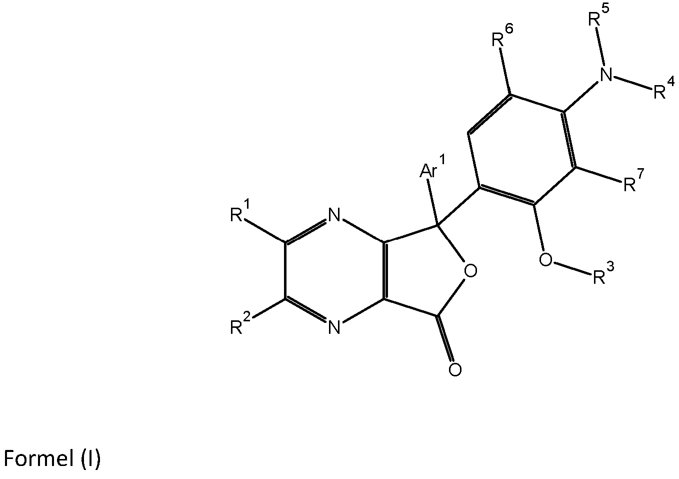 wobei:
Ar¹ eine substituierte oder unsubstituierte Aryl- oder eine substituierte oder unsubstituierte Heteroarylgruppe ist;
R¹ und R² unabhängig Wasserstoff, substituierte oder unsubstituierte Alkylgruppen, welche jeweils 1 bis 12 Kohlenstoffatome aufweisen, substituierte oder unsubstituierte Arylgruppen, oder substitutierte oder unsubstitutierte heteroaromatische Gruppen darstellen, oder R¹ und R² verbunden sein können, um einen kondensierten Ring zu bilden;
R³ eine substituierte oder unsubstituierte Alkylgruppe mit 1 bis 12 Kohlenstoffatomen, eine substituierte oder unsubstituierte Aryl- oder eine substituierte oder unsubstituierte Heteroarylgruppe darstellt;
R⁴ und R⁵ unabhängig Wasserstoff, substituierte oder unsubstituierte Alkylgruppen, welche jeweils 1 bis 12 Kohlenstoffatome aufweisen, substituierte oder unsubstituierte Arylgruppen, oder substituierte oder unsubstituierte heteroaromatische Gruppen darstellen; und
R⁶ und R⁷ unabhängig Wasserstoff oder substituierte oder unsubstituierte Alkylgruppen mit 1 bis 12 Kohlenstoffen darstellen,
oder R⁴ und R⁶ verbunden sein können, um eine cyclische Struktur zu bilden, oder R⁵ und R⁷ verbunden sein können, um eine cyclische Struktur zu bilden, oder einer oder beide von R⁴ und R⁵ mit R⁶ beziehungsweise R⁷ verbunden sein können;
(4) ein infrarotabsorbierendes Material; und
(5) eine farbverändernde Verbindung, die entweder durch Formel (III) oder Formel (IV) dargestellt wird: 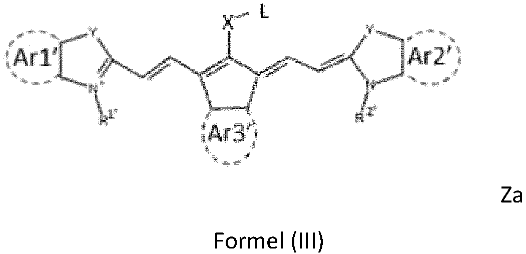 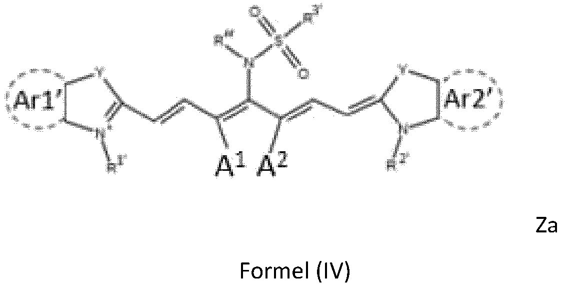 wobei:
Ar1', Ar2' und Ar3' unabhängig die Atome darstellen, welche nötig sind, um substituierte oder unsubstituierte aromatische Ringe zu vervollständigen oder substituierte oder unsubstituierte heteroaromatische Ringe zu vervollständigen;
Y ein Sauerstoffatom, ein Schwefelatom oder eine Dialkylmethylengruppe, dargestellt durch >C(R^{4'}R^{5'}) darstellt, wobei R^{4'} und R^{5'} unabhängig substituierte oder unsubstituierte Alkylgruppen mit jeweils 1 bis 4 Kohlenstoffen darstellen;
R" Wasserstoff, eine substituierte oder unsubstituierte Alkylgruppe, eine substituierte oder unsubstituierte Arylgruppe oder eine substituierte oder unsubstituierte Heteroarylgruppe darstellt;
R^{1'} und R^{2'} unabhängig substituierte oder unsubstituierte Alkylgruppen darstellen;
X eine Einfachbindung oder eine zweiwertige Verbindungsgruppe, ausgewählt aus -S-, -O- und >N(R^{6'}) darstellt, wobei R^{6'} Wasserstoff, eine substituierte oder unsubstituierte Alkylgruppe, eine substituierte oder unsubstituierte Arylgruppe, eine substituierte oder unsubstituierte Heteroarylgruppe oder L darstellt;
L eine -C(=O)-OR^{7'}-Gruppe, -SO₂-R^{3'}-Gruppe, oder -SO₂NR^{8'}R^{9'}-Gruppe darstellt, wobei R^{7'} eine substituierte oder unsubstituierte Alkylgruppe darstellt, welche ein sekundäres oder tertiäres Verbindungskohlenstoffatom aufweist, das mit dem Rest der -C(=O)OR^{7'}-Gruppe verbunden ist; und R^{3'}, R^{8'} and R^{9'} unabhängig substituierte oder unsubstituierte Alkylgruppen, substituierte oder unsubstituierte Arylgruppen oder substituierte oder unsubstituierte Heteroarylgruppen darstellen; R^{7'} Wasserstoff, eine substituierte oder unsubstituierte Alkylgruppe, eine substituierte oder unsubstituierte Arylgruppe oder eine substituierte oder unsubstituierte Heteroarylgruppe darstellt;
A¹ und A² unabhängig substituierte oder unsubstituierte Alkylgruppen darstellen oder zusammen die zwei oder drei Kohlenstoffatome darstellen, welche nötig sind, um einen substituierten oder unsubstituierten 5- oder 6-gliedrigen nichtaromatischen carbocyclischen Ring zu bilden; und
Za ein oder mehrere Gegenionen darstellt, um die elektrische Ladung in dem Rest der farbverändernden Verbindung gemäß Formel (III) oder Formel (IV) auszugleichen, und
wobei die Boratverbindung durch die folgende Formel (VI) dargestellt ist:
[B(R^{10'}R^{11'}R^{12'}R^{13'})⁻]ₙ Mⁿ⁺ Formel (VI)
wobei R^{10'}, R^{11'}, R^{12'} und R^{13'} unabhängig substituierte oder unsubstituierte Alkylgruppen oder substituierte oder unsubstituierte Arylgruppen darstellen und mindestens drei von R^{10'}, R^{11'}, R^{12'} und R^{13'} substituierte oder unsubstituierte Arylgruppen darstellen; Mⁿ⁺ ein n-wertiges Kation ist und n eine positive ganze Zahl ist;
wobei Infrarotstrahlung eine Strahlung mit einer Wellenlänge von mindestens 750 nm und höher ist.

2. Der Lithographiedruckplattenvorläufer gemäß Anspruch 1, wobei R³ eine substituierte oder unsubstituierte Alkylgruppe mit 1 bis 6 Kohlenstoffatomen darstellt.

3. Der Lithographiedruckplattenvorläufer gemäß Anspruch 1 oder 2, wobei R⁴ und R⁵ unabhängig substituierte oder unsubstituierte Alkylgruppen mit jeweils 1 bis 6 Kohlenstoffatomen darstellen.

4. Der Lithographiedruckplattenvorläufer gemäß einem der Ansprüche 1 bis 3, wobei Ar¹ eine der folgenden Gruppen darstellt: 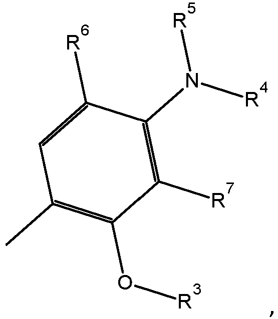 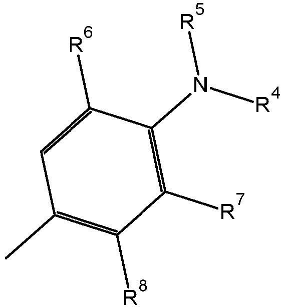 und 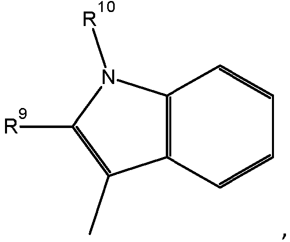 wobei R³, R⁴, R⁵, R⁶ und R⁷ wie vorstehend definiert sind, und R⁸, R⁹ und R¹⁰ unabhängig Wasserstoff oder substituierte oder unsubstituierte Alkylgruppen mit jeweils 1 bis 12 Kohlenstoffatomen darstellen.

5. Der Lithographiedruckplattenvorläufer gemäß einem der Ansprüche 1 bis 4, wobei die Komponente (3), säureempfindliche farbverändernde Verbindung, durch die Formel (II) dargestellt ist 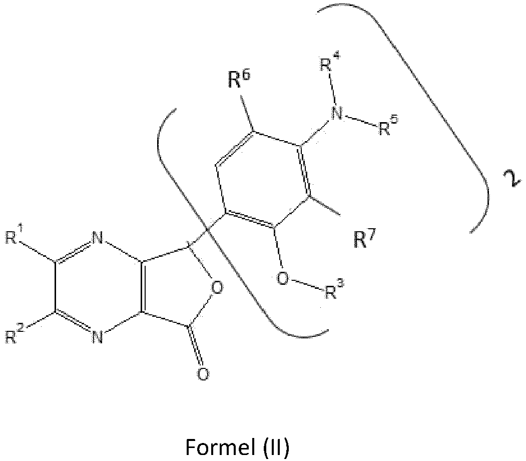 wobei R¹ bis R⁷ die gleichen Bedeutungen wie für Formel (I) haben.

6. Der Lithographiedruckplattenvorläufer gemäß einem der Ansprüche 1 bis 5, wobei die Komponente (1), radikalische Initiatorzusammensetzung, ein Diaryliodonium-Kation umfasst.

7. Der Lithographiedruckplattenvorläufer gemäß einem der Ansprüche 1 bis 6, wobei die Boratverbindung ein Tetraphenylboratanion umfasst.

8. Der Lithographiedruckplattenvorläufer gemäß einem der Ansprüche 1 bis 7, wobei die infrarotstrahlungsempfindliche Bildaufzeichnungsschicht ferner eine Komponente (6). nicht radikalisch polymerisierbares polymeres Material, umfasst, das von allen vorstehend definierten Komponenten (1), (2), (3) und (4) verschieden ist.

9. Der Lithographiedruckplattenvorläufer gemäß einem der Ansprüche 1 bis 8, wobei die Komponente (3), säureempfindliche farbverändernde Verbindung, dargestellt durch Formel (I) in der infrarotstrahlungsempfindlichen Bildaufzeichnungsschicht in einer Trockenbedeckungsmenge von mindestens 0,5 Gew.-% und bis zu und einschließlich 15 Gew.-% vorhanden ist, bezogen auf die gesamte Trockenbedeckungsmenge der infrarotstrahlungsempfindlichen Bildaufzeichnungsschicht.

10. Der Lithographiedruckplattenvorläufer gemäß einem der Ansprüche 1 bis 9, wobei die infrarotstrahlungsempfindliche Bildaufzeichnungsschicht die äußerste Schicht ist.

11. Der Lithographiedruckplattenvorläufer gemäß einem der Ansprüche 1 bis 10, wobei die infrarotstrahlungsempfindliche Bildaufzeichnungsschicht ferner eine oder mehrere Verbindung(en) umfasst, von denen jede durch die folgende Struktur (P) dargestellt ist: 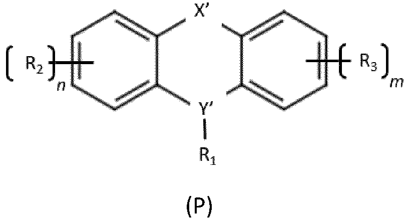 wobei in Struktur (P):
X' eine der zweiwertigen Gruppen -O-, -S-, -NH- oder -CH₂- darstellt;
Y' eine der dreiwertigen Gruppen >N- oder >CH- darstellt;
R₁ Wasserstoff oder eine substituierte oder unsubstituierte Alkylgruppe darstellt;
R₂ und R₃ unabhängig Halogen, Thioalkyl-, Thiophenyl-, Alkoxy-, Phenoxy-, Alkyl- , Phenyl-, Thioacetyl- oder Acetylgruppen darstellen; und
m und n unabhängig für 0 oder eine ganze Zahl von 1 bis 4 stehen.

12. Der Lithographiedruckplattenvorläufer gemäß einem der Ansprüche 1 bis 11, wobei das Substrat ein Aluminium enthaltendes Substrat, umfassend mindestens eine innere Aluminiumoxidschicht, eine äußere Aluminiumoxidschicht, welche auf der inneren Aluminiumoxidschicht angeordnet ist, und eine Beschichtung mit hydrophilem Polymer, welche auf der äußeren Aluminiumoxidschicht angeordnet ist, umfasst.

13. Ein Verfahren zur Bereitstellung einer Lithographiedruckplatte, umfassend:
A) bildweises Belichten des Lithographiedruckplattenvorläufers gemäß einem der Ansprüche 1 bis 12 mit Infrarotstrahlung, um mit Infrarotstrahlung belichtete Bereiche und nicht mit Infrarotstrahlung belichtete Bereiche in der infrarotstrahlungsempfindlichen Bildaufzeichnungsschicht bereitzustellen, und
B) Entfernen der nicht mit Infrarotstrahlung belichteten Bereiche in der infrarotstrahlungsempfindlichen Bildaufzeichnungsschicht von dem Substrat;
wobei Infrarotstrahlung eine Strahlung mit einer Wellenlänge von mindestens 750 nm und höher ist.

14. Das Verfahren gemäß Anspruch 13, umfassend das Entfernen der nicht mit Infrarotstrahlung belichteten Bereiche in der infrarotstrahlungsempfindlichen Bildaufzeichnungsschicht von dem Substrat auf der Druckmaschine unter Verwendung einer lithographischen Druckfarbe, eines Feuchtmittels oder einer Kombination aus einer lithographischen Druckfarbe und eines Feuchtmittels.

15. Das Verfahren gemäß Anspruch 13 oder 14, wobei der Unterschied in der Reflexionsabsorption zwischen den mit Infrarotstrahlung belichteten Bereichen und den nicht mit Infrarotstrahlung belichteten Bereichen in der infrarotstrahlungsempfindlichen Bildaufzeichnungsschicht unmittelbar nach Schritt (A) mindestens 0,02 beträgt und/oder Schritt (A) bei oder unter 120 mJ/cm² Infrarotstrahlungsenergie durchgeführt wird.

## Revendications

1. Précurseur de plaque d'impression lithographique comprenant :
un substrat, et
une couche d'enregistrement d'image sensible au rayonnement infrarouge disposée sur le substrat, la couche d'enregistrement d'image sensible au rayonnement infrarouge comprenant les constituants (1), (2), (3), (4) et (5) suivants :
(1) une composition d'initiateur de radicaux libres qui est capable de générer des radicaux libres lors d'une exposition à un rayonnement infrarouge et comprend un composé borate ;
(2) une composition polymérisable par radicaux libres ;
(3) un composé changeant de couleur sensible à l'acide qui est représenté par la Formule (I) suivante : 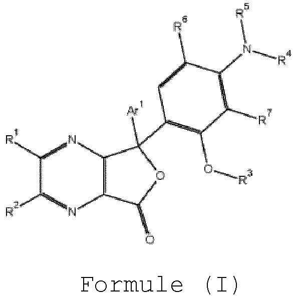 dans laquelle :
Ar¹ est un aryle substitué ou non substitué ou un groupe hétéroaryle substitué ou non substitué ;
R¹ et R² sont indépendamment de l'hydrogène, des groupes alkyle substitués ou non substitués, chacun ayant 1 à 12 atomes de carbone, des groupes aryle substitués ou non substitués, ou des groupes hétéroaromatiques substitués ou non substitués, ou R¹ et R² peuvent être reliés pour former un anneau fusionné ;
R³ est un groupe alkyle substitué ou non substitué ayant 1 à 12 carbones, un aryle substitué ou non substitué ou un groupe hétéroaryle substitué ou non substitué ;
R⁴ et R⁵ sont indépendamment de l'hydrogène, des groupes alkyle substitués ou non substitués, chacun ayant 1 à 12 atomes de carbone, des groupes aryle substitués ou non substitués ou des groupes hétéroaromatiques substitués ou non substitués ; et
R⁶ et R⁷ sont indépendamment de l'hydrogène ou des groupes alkyle substitués ou non substitués ayant 1 à 12 carbones,
ou R⁴ et R⁶ peuvent être liés ensemble pour former une structure cyclique, ou R⁵ et R⁷ peuvent être liés ensemble pour former une structure cyclique, ou un ou les deux parmi R⁴ et R⁵ peuvent être liés à R⁶ et R⁷, respectivement ;
(4) un matériau à absorption infrarouge ; et
(5) un composé changeant de couleur représenté par la Formule (III) ou la Formule (IV) : 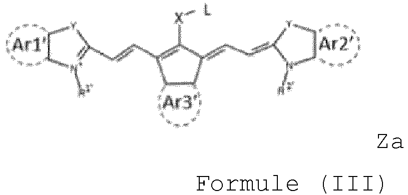 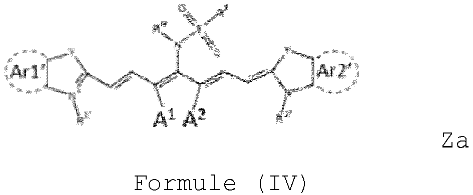 dans lesquelles :
Ar1', Ar2' et Ar3' représentent indépendamment les atomes nécessaires pour compléter des anneaux aromatiques substitués ou non substitués ou pour compléter des anneaux hétéroaromatiques substitués ou non substitués ;
Y représente un atome d'oxygène, un atome de soufre ou un groupe dialkylméthylène représenté par >C(R^{4'} R^{5'}) dans lequel R^{4'} et R^{5'} sont indépendamment des groupes alkyle substitués ou non substitués, chacun ayant 1 à 4 carbones ;
R" est de l'hydrogène, un groupe alkyle substitué ou non substitué, un groupe aryle substitué ou non substitué ou un groupe hétéroaryle substitué ou non substitué ;
R^{1'} et R^{2'} sont indépendamment des groupes alkyle substitués ou non substitués ;
X représente une liaison simple ou un groupe de liaison divalent sélectionné parmi -S-, -O- et >N(R^{6'}) dans lequel R^{6'} est de l'hydrogène, un groupe alkyle substitué ou non substitué, un groupe aryle substitué ou non substitué, un groupe hétéroaryle substitué ou non substitué ou L ;
L représente un groupe -C(=O)-OR^{7'}, un groupe -SO₂-R^{3'} ou un groupe -SO₂NR^{8'}R^{9'}, dans lesquels R^{7'} représente un groupe alkyle substitué ou non substitué qui a un carbone de liaison secondaire ou tertiaire qui est relié au reste du groupe -C(=O)OR^{7'} ; et R^{3'}, R^{8'} et R^{9'} représentent indépendamment des groupes alkyle substitués ou non substitués, des groupes aryle substitués ou non substitués ou des groupes hétéroaryle substitués ou non substitués ; R^{7'} est de l'hydrogène, un groupe alkyle substitué ou non substitué, un groupe aryle substitué ou non substitué ou un groupe hétéroaryle substitué ou non substitué ;
A¹ et A² représentent indépendamment des groupes alkyle substitués ou non substitués, ou ensemble ils représentent les deux ou trois atomes de carbone nécessaires pour former un anneau carbocyclique non aromatique à 5 ou 6 éléments substitué ou non substitué ; et
Za représente un ou plusieurs contre-ions pour équilibrer la charge électrique dans le reste du composé changeant de couleur selon la Formule (III) ou la Formule (IV), et
dans lequel le composé borate est représenté par la Formule (VI) suivante :
[B(R^{10'}R^{11'}R^{12'}R^{13'})⁻]ₙMⁿ⁺ Formule (VI)
dans laquelle R^{10'}, R^{11'}, R^{12'} et R^{13'} sont indépendamment des groupes alkyle substitués ou non substitués ou des groupes aryle substitués ou non substitués, et au moins trois parmi R^{10'}, R^{11'}, R^{12'} et R^{13'} sont des groupes aryle substitués ou non substitués ; Mⁿ⁺ est un cation n-valent et n est un nombre entier positif ;
dans lequel le rayonnement infrarouge est un rayonnement ayant une longueur d'onde d'au moins 750 nm et plus.

2. Précurseur de plaque d'impression lithographique selon la revendication 1, dans lequel R³ est un groupe alkyle substitué ou non substitué ayant 1 à 6 atomes de carbone.

3. Précurseur de plaque d'impression lithographique selon la revendication 1 ou 2, dans lequel R⁴ et R⁵ sont indépendamment des groupes alkyle substitués ou non substitués, chacun ayant 1 à 6 atomes de carbone.

4. Précurseur de plaque d'impression lithographique selon l'une quelconque des revendications 1 à 3, dans lequel Ar¹ est l'un des groupes suivants : 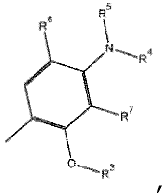 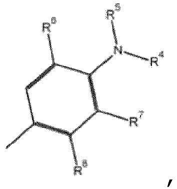 et 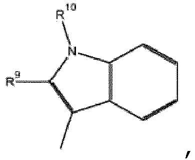 dans lesquels R³, R⁴, R⁵, R⁶ et R⁷ sont tels que définis ci-dessus, et R⁸, R⁹ et R¹⁰ sont indépendamment de l'hydrogène ou des groupes alkyle substitués ou non substitués, chacun ayant 1 à 12 atomes de carbone.

5. Précurseur de plaque d'impression lithographique selon l'une quelconque des revendications 1 à 4, dans lequel le constituant (3) composé changeant de couleur sensible à l'acide est représenté par la Formule (II) 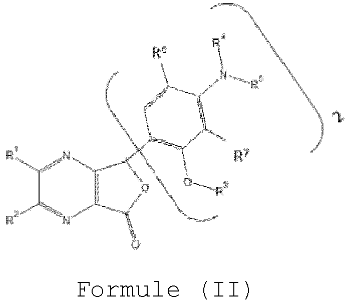 dans laquelle R¹ à R⁷ ont les mêmes significations que pour la Formule (I).

6. Précurseur de plaque d'impression lithographique selon l'une quelconque des revendications 1 à 5, dans lequel le constituant (1) composition d'initiateur de radicaux libres comprend un cation diaryliodonium.

7. Précurseur de plaque d'impression lithographique selon l'une quelconque des revendications 1 à 6, dans lequel le composé borate comprend un anion tétraphénylborate.

8. Précurseur de plaque d'impression lithographique selon l'une quelconque des revendications 1 à 7, dans lequel la couche d'enregistrement d'image sensible au rayonnement infrarouge comprend en outre un constituant (6) de matériau polymère non polymérisable par radicaux libres qui est différent de tous les constituants (1), (2), (3) et (4) définis ci-dessus.

9. Précurseur de plaque d'impression lithographique selon l'une quelconque des revendications 1 à 8, dans lequel le constituant (3) composé changeant de couleur sensible à l'acide représenté par la Formule (I) est présent dans la couche d'enregistrement d'image sensible au rayonnement infrarouge en une quantité de couverture sèche d'au moins 0,5 % en poids et jusqu'à et comportant 15 % en poids, sur la base de la couverture sèche totale de la couche d'enregistrement d'image sensible au rayonnement infrarouge.

10. Précurseur de plaque d'impression lithographique selon l'une quelconque des revendications 1 à 9, dans lequel la couche d'enregistrement d'image sensible au rayonnement infrarouge est la couche la plus extérieure.

11. Précurseur de plaque d'impression lithographique selon l'une quelconque des revendications 1 à 10, dans lequel la couche d'enregistrement d'image sensible au rayonnement infrarouge comprend en outre un ou plusieurs composés, chacun d'entre eux étant représenté par la Structure (P) suivante : 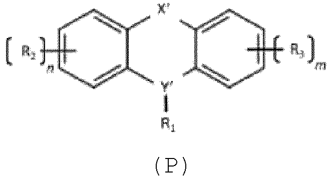 dans lequel dans la Structure (P) :
X' est l'un des groupes divalents -O-, -S-, -NH- ou -CH₂- ;
Y' est l'un des groupes trivalents >N- ou >CH- ;
R₁ est de l'hydrogène ou un groupe alkyle substitué ou non substitué ;
R₂ et R₃ sont indépendamment des groupes halo, thioalkyle, thiophényle, alcoxy, phénoxy, alkyle, phényle, thioacétyl ou acétyle ; et
m et n sont indépendamment 0 ou un nombre entier de 1 à 4.

12. Précurseur de plaque d'impression lithographique selon l'une quelconque des revendications 1 à 11, dans lequel le substrat comprend un substrat contenant de l'aluminium comprenant au moins une couche d'oxyde d'aluminium intérieure, une couche d'oxyde d'aluminium extérieure disposée sur la couche d'oxyde d'aluminium intérieure et un revêtement polymère hydrophile qui est disposé sur la couche d'oxyde d'aluminium extérieure.

13. Méthode pour fournir une plaque d'impression lithographique, comprenant :
A) l'exposition sur le plan image du précurseur de plaque d'impression lithographique selon l'une quelconque des revendications 1 à 12 à un rayonnement infrarouge, pour fournir des régions exposées au rayonnement infrarouge et des régions non exposées au rayonnement infrarouge dans la couche d'enregistrement d'image sensible au rayonnement infrarouge, et
B) l'élimination des régions non exposées au rayonnement infrarouge dans la couche d'enregistrement d'image sensible au rayonnement infrarouge du substrat ;
dans laquelle le rayonnement infrarouge est un rayonnement ayant une longueur d'onde d'au moins 750 nm et plus.

14. Méthode selon la revendication 13, comprenant l'élimination des régions non exposées au rayonnement infrarouge dans la couche d'enregistrement d'image sensible au rayonnement infrarouge du substrat sur presse en utilisant une encre d'impression lithographique, une solution de mouillage ou une combinaison d'une encre d'impression lithographique et d'une solution de mouillage.

15. Méthode selon la revendication 13 ou 14, dans laquelle la différence d'absorbance réfléchissante entre des régions exposées au rayonnement infrarouge et des régions non exposées au rayonnement infrarouge dans la couche d'enregistrement d'image sensible au rayonnement infrarouge immédiatement après l'étape (A) est d'au moins 0,02, et/ou l'étape (A) est réalisée à une énergie de rayonnement infrarouge de 120 mJ/cm² ou moins.
